# EUROPEAN PATENT SPECIFICATION

(11) **EP 0 786 536 B1**
(45) Date of publication and mention of the grant of the patent: **07.05.2003**
(21) Application number: 97100088.0
(22) Date of filing: 04.01.1997
(51) Int. Cl.: C23C 16/40, B23B 27/14

(54) **Coated cutting tool**
Beschichtetes Schneidwerkzeug
Outil de coupe revêtu

(30) Priority: 24.01.1996 JP 993096; 25.03.1996 JP 6811596; 25.03.1996 JP 6812096; 16.04.1996 JP 9396796
(43) Date of publication of application: 30.07.1997
(73) Proprietor: MITSUBISHI MATERIALS CORPORATION, Chiyoda-ku, Tokyo 100 (JP)
(72) Inventor: Ueda, Toshiaki, Mitsubishi Materials Corporation, Ishigemachi, Yuuki-gum, Ibaragi-ken (JP); Nakamura, Eiji Mitsubishi Materials Corp., Omiya, Saitama 330 (JP); Yamada, Takashi, Mitsubishi Materials Corporation, Ishigemachi, Yuuki-gun, Ibaragi-ken (JP); Oshika, Takatoshi, Mitsubishi Materials Corp., Omiya, Saitama 330 (JP)
(74) Representative: Gille Hrabal Struck Neidlein Prop Roos

(56) References cited:
- WO-A-92/17623
- FR-A- 2 393 852
- US-A- 4 112 148
- PLASMA CHEMISTRY AND PLASMA PROCESSING, vol. 12, no. 2, 1 June 1992, pages 129-145, XP000266311 PATSCHEIDER J ET AL: "PLASMA-INDUCED DEPOSITION OF THIN FILMS OF ALUMINUM OXIDE"
- BERICHTE DER DEUTSCHEN KERAMISCHEN GESELLSCHAFT, MARCH 1972, WEST GERMANY, vol. 49, no. 3, ISSN 0365-9542, pages 76-80, XP000671483 SCHACHNER H ET AL: "Chemical vapour deposition of aluminium oxide layers on aluminium by hydrolysis of aluminium chloride"

## Description

### BACKGROUND OF THE INVENTION

### 1. Field of the Invention

The present invention relates to a cutting tool whose cutting member made of a coated carbide alloy (hereinafter referred to as "coated carbide cutting member") in which a thick, uniform Al₂O₃-based layer essentially consisting of aluminum oxide (hereinafter Al₂O₃) is formed as a hard coating layer. The cutting member exhibits no chipping in continuous and interrupted cutting of, for example, steel or cast iron and exhibits stable cutting ability for long periods. Inventors use the term "cutting member" as those which have a function to actually cut off the metal work piece, mainly like exchangeable cutting insert to be mounted on face milling cutter body, bit shank of turning tool, and cutting blade of end mill.

### 2. Description of the Related Art

Coated carbide cutting members have been known in which the cutting members comprise a tungsten carbide substrate (hereinafter carbide substrate) and hard coating layers comprising an Al₂O₃ layer and at least one layer, for example, selected from the group consisting of a titanium carbide (TiC) layer, a titanium nitride (TiN) layer, a titanium carbonitride (TiCN) layer, a titanium oxide (TiO₂) layer, a titanium carboxide (TiCO) layer, a titanium nitroxide (TiNO) layer, and a titanium carbonitroxide (TiCNO) layer and the hard coating layer is formed by chemical and/or physical vapor deposition and has an average thickness of 3 to 20 µm.

Further, it has been known that the Al₂O₃ layer composing the hard coating layer is formed from a reactive gas comprising
1 to 20 percent by volume of aluminum trichloride (AlCl₃),
0.5 to 30 percent by volume of carbon dioxide (CO₂),
1 to 30 percent by volume of carbon monoxide (CO) or hydrogen chloride (HCl) if necessary, and
the balance being hydrogen,
at a reaction temperature of 950 to 1,100 °C and an ambient pressure of 2,67 to 26,67 kPa (20 to 200 torr).

Recently, highly durable coated carbide cutting members have been in demand with the promotion of factory automation and labor saving in cutting. Among hard coating layers, thickening of the Al₂O₃ layer exhibits excellent resistance against oxidation, thermal stability and high hardness, and has been investigated in response to such demands. However, it is inevitable that the Al₂O₃ layer creates local nonuniformities in conventional deposition processes for thickening, and the resulting cutting members have significant nonuniformity in thickness between the flank, rake and edge (the cross of the flank and the rake). When such cutting members are used for interrupted cutting of steel and cast iron, cutting tool chipping easily forms, resulting in a relatively short duration.

### SUMMARY OF THE INVENTION

The present inventors have investigated the improvement in resistance against chipping of a deposited Al₂O₃ layer composing a hard coating layer of a coated carbide cutting member. As a result, it has been found that a deposited Al₂O₃ layer (hereinafter Al₂O₃-based layer) which is formed by the following process exhibits excellent resistance against oxidation and thermal stability and high hardness: The Al₂O₃-based layer is formed by CVD or plasma CVD using a reactive gas containing 1 to 10 percent by volume (hereinafter merely percent of AlCl₃, 1 to 5 percent of hydrogen (H₂), 5 to 15 percent of nitrogen oxide (NOₓ), and 0.05 to 0.7 percent of titanium tetrachloride (TiCl₄) in an inert carrier gas at a temperature of 850 to 1,150 °C and a pressure of 2,67 to 26,67 kPa (20 to 200 torr). The resulting layer contains chlorine. The crystals in the layer are fined by controlling the chlorine content from 0.005 to 0,3 percent by weight (hereinafter merely percent). Further, local fluctuation in the thickness caused by thickening of the layer can be significantly reduced by controlling the composition of the reactive gas and the ambience so that the Ti content is 1.5 to 15 percent and the Cl content is 0.05 to 0,3 percent in the layer, thus the resulting cutting member has excellent uniformity in thicknesses between the flank, rake and edge (the cross of the flank and the rake). Moreover, coarsening of crystal grains in the thick layer can be reduced by controlling the Zr and/or Hf contents from 0.5 to 10 percent. A coated carbide cutting member comprising a hard coating layer including the Al₂O₃-based layer is durable to long-term continuous and interrupted cutting of steel and cast iron without chipping of the cutting member.

In accordance with the present invention, a coated carbide alloy cutting member exhibiting excellent resistance against chipping comprises: a tungsten carbide substrate and hard coating layers including an aluminum oxide-based layer essentially consisting of aluminum oxide having an average thickness of 3 to 20 µm and formed on the tungsten carbide substrate by chemical and/or physical vapor deposition; wherein the aluminum oxide-based layer contains 0.005 to 0,3 percent by weight of chlorine. The improvement in resistance against chipping may be due to fining of crystal grains in the deposited layer.

### DESCRIPTION OF THE PREFERRED EMBODIMENT

In the present invention, the Cl content of the Al₂O₃-based layer composing the hard coating layer of the coated carbide cutting member is determined to be 0.005 to 0,3 percent by weight (hereinafter merely percent). When the Cl content is less than 0.005 percent, the advantages set forth above cannot be achieved. On the other hand, a Cl content of over 0,3 percent loses characteristics, in particular wear resistance inherent to the Al₂O₃-based layer.

A layer having a uniform thickness can be formed in the presence of both Ti and Cl components. Satisfactory results cannot be achieved if the Ti content is less than 1.5 percent or the Cl content is less than 0.005 percent. On the other hand, excellent characteristics inherent to the Al₂O₃-based layer deteriorate if the Ti content exceeds 15 percent or the Cl content exceeds 0,3 percent. Thus, the Ti content is set from 1.5 to 15 percent and the Cl content is set from 0.005 to 0,3 percent.

Coarsening of crystal grains decreases the excellent characteristics of the Al₂O₃-based layer, but this can be reduced with Zr and/or Hf, particularly in the case of thicker layers. Satisfactory results cannot be achieved if the content is less than 0.5 percent. On the other hand, excellent characteristics inherent to the Al₂O₃-based layer deteriorate if the content exceeds 10 percent. Thus, the Zr and/or Hf content is set from 0.5 to 10 percent.

It is preferable that the total content of Ti, Cl, Zr and Hf in the Al₂O₃-based layer be controlled to be within 17.5 percent by weight, because the wear resistance significantly decreases if the total content exceeds the upper limit set forth above.

The average thickness of the hard coating layer is set to be 3 to 20 µm. Excellent wear resistance cannot be achieved at a thickness of less than 3 µm, whereas damage and chipping of the cutting member easily occur at a thickness of over 20 µm.

### EXAMPLES

The coated carbide cutting member in accordance with the present invention will now be illustrated in detail with reference to the following EXAMPLES.

### EXAMPLE 1

The following powders were prepared as raw materials: a WC powder with an average grain size of 2.8 µm; a coarse WC powder with an average grain size of 4.9 µm; a TiC/WC powder with an average grain size of 1.5 µm (TiC/WC = 30/70 by weight ; a (Ti,W)CN powder with an average grain size of 1.2 µm (TiC/TiN/WC = 24/20/56); a TaC/NbC powder with an average grain size of 1.2 µm (TaC/NbC = 90/10); and a Co powder with an average grain size of 1.1 µm. These powders were compounded based on the formulation shown in Table 1, wet-mixed in a ball mill for 72 hours, and dried. The dry mixture was pressed to form a green compact for cutting insert defined in ISO-CNMG120408 (for carbide substrates A through D) or ISO-SEEN42AFTN1 (for carbide substrate E , followed by vacuum sintering under the conditions set forth in Table 1. Carbide substrates A through E were prepared in such a manner.

The carbide substrate B was held in a CH₄ atmosphere of 13,33 kPa (100 torr) at 1400 °C for 1 hour, followed by annealing for carburization. The carburized substrate was subjected to treatment by acid and barrel finishing to remove carbon and cobalt on the substrate surface. The substrate was covered with a Co-enriched zone having a thickness of 42 µm and a maximum Co content of 15.9 percent by weight at a depth 11 µm from the surface of the substrate.

Sintered carbide substrates A and D have a Co-enriched zone having a thickness of 23 µm and a maximum Co content of 9.1 percent by weight at a depth 17 µm from the surface of the substrate. Carbide substrates C and E have no Co-enriched zone and have homogeneous microstructures.

The Rockwell hardness (Scale A) of each of the carbide substrates A through E are shown in Table 1.

The surfaces of the carbide substrates A through E were subjected to honing and chemical vapor deposition using conventional equipment under the conditions shown in Tables 2 or 3 to form hard coating layers having a composition and a designed thickness (at the flank of the cutting insert), wherein l-TiCN in Table 2 represents TiCN having a crystal structure longitudinally grown described in Japanese Unexamined Patent Publication No. 6-8010, p-TiCN in the same table represents TiCN having a general crystal grain structure, each Al₂O₃ (a) through (e) in Table 3 represents an Al₂O₃-based layer, and Al₂O₃ (f) represents an Al₂O₃ layer (the same as in Tables 4 and 5). Coated carbide cutting inserts in accordance with the present invention 1 through 10 and conventional coated carbide cutting inserts 1 through 10 were produced in such a manner.

The resulting coated carbide cutting inserts were subjected to measurement of the maximum thickness of the cutting edge, at which the flank and the rake cross each other, of the Al₂O₃-based layer and the Al₂O₃ layer (in Tables 6 and 7, both are referred to as merely Al₂O₃ layer) as the hard coating layer. Further, the thicknesses of those layers at the flank and rake at positions 1 mm from the cutting edge were measured. These results are shown in Tables 6 and 7.

In the hard coated layer, the thicknesses of layers other than both the Al₂O₃ layer and the Al₂O₃-based layer do not have substantial local fluctuations and are identical to the designed thicknesses.

The Al₂O₃-based layer of the cutting insert in accordance with the present invention or the conventional Al₂O₃ layer was subjected to elemental analysis using an EPMA (electron probe micro analyzer). When the top surface is a TiN layer, the TiN layer was removed with aqueous hydrogen peroxide before the analysis. The cutting inserts used for elemental analysis are identical to the ones used in the cutting test. The elemental analysis was carried out by irradiating an electron beam having a diameter of 1 mm onto the center of the flank for cutting inserts having a shape defined in ISO-CNMG120408 or onto the center of the rake for cutting inserts having a shape defined in ISO-SEEN42AFTN1.

As a result, the Al₂O₃-based layers of the coated carbide cutting inserts in accordance with the present invention contain 52.8 to 53.1 percent by weight of Al, and 46.5 to 46.9 percent by weight of O, 0.014 to 0.38 percent by weight of Cl, whereas conventional Al₂O₃ layers contain 52.8 to 53.0 percent by weight of Al and 47.0 to 47.2 percent by weight of O, and Cl was not detected.

Resistances against chipping of coated carbide cutting inserts in accordance with the present invention 1 and 2 and conventional coated carbide cutting inserts 1 and 2 were evaluated by dry continuous and interrupted cutting tests as follows:
Conditions for dry continuous cutting test of ductile cast iron
   Material to be cut: round bar based on JIS-FCD450
   Cutting speed: 200 m/min.
   Depth of cut: 2.0 mm
   Feed rate: 0.3 mm/rev.
   Cutting time: 20 minutes
Conditions for dry interrupted cutting test of ductile cast iron
   Material to be cut: round bar based on JIS-FCD450 with four longitudinal grooves equally spaced
   Cutting speed: 150 m/min.
   Depth of cut: 2.0 mm
   Feed rate: 0.25 mm/rev.
   Cutting time: 5 minutes
The resistances against chipping in both tests were evaluated by flank wear.

Resistances against chipping of coated carbide cutting inserts in accordance with the present invention 3 and 4 and conventional coated carbide cutting inserts 3 and 4 were evaluated by dry continuous and interrupted cutting tests as follows:
Conditions for dry continuous cutting test of alloy steel
   Material to be cut: round bar based on JIS-SNCM439
   Cutting speed: 200 m/min.
   Depth of cut: 2.0 mm
   Feed rate: 0.3 mm/rev.
   Cutting time: 20 minutes
Conditions for dry interrupted cutting test of alloy steel
   Material to be cut: round bar based on JIS-SNCM439 with four longitudinal grooves equally spaced
   Cutting speed: 150 m/min.
   Depth of cut: 2.0 mm
   Feed rate: 0.25 mm/rev.
   Cutting time: 5 minutes
The resistances against chipping in both tests were evaluated by flank wear.

Resistances against chipping of coated carbide cutting inserts in accordance with the present invention 5 and 6 and conventional coated carbide cutting inserts 5 and 6 were evaluated by dry continuous and interrupted cutting tests as follows:
Conditions for dry continuous cutting test of carbon steel
   Material to be cut: round bar based on JIS-S45C
   Cutting speed: 200 m/min.
   Depth of cut: 2.0 mm
   Feed rate: 0.3 mm/rev.
   Cutting time: 20 minutes
Conditions for dry interrupted cutting test of carbon steel
   Material to be cut: round bar based on JIS-S45C with four longitudinal grooves equally spaced
   Cutting speed: 150 m/min.
   Depth of cut: 2.0 mm
   Feed rate: 0.25 mm/rev.
   Cutting time: 5 minutes
The resistances against chipping in both tests were evaluated by flank wear.

Resistances against chipping of coated carbide cutting inserts in accordance with the present invention 6 and 8 and conventional coated carbide cutting inserts 7 and 8 were evaluated by dry continuous and interrupted cutting tests as follows:
Conditions for dry continuous cutting test of cast iron
   Material to be cut: round bar based on JIS-FC300
   Cutting speed: 250 m/min.
   Depth of cut: 2.0 mm
   Feed rate: 0.3 mm/rev.
   Cutting time: 20 minutes
Conditions for dry interrupted cutting test of cast iron
   Material to be cut: round bar based on JIS-FC300 with four longitudinal grooves equally spaced
   Cutting speed: 150 m/min.
   Depth of cut: 2.0 mm
   Feed rate: 0.25 mm/rev.
   Cutting time: 5 minutes
The resistances against chipping in both tests were evaluated by flank wear.

Resistances against chipping of coated carbide cutting inserts in accordance with the present invention 9 and 10 and conventional coated carbide cutting inserts 9 and 10 were evaluated by a dry milling test as follows:
Conditions for dry milling test of alloy steel
   Material to be cut: square bar of 100-mm wide and 500-mm long based on JIS-SCM440
   Cutting tool configuration: single cutting insert mounted with a cutter of 125-mm diameter
   Rotation: 510 r.p.m.
   Cutting speed: 200 m/min.
   Depth of cut: 1.5 mm
   Feed rate: 0.2 mm/tooth
   Cutting time: 3 passes (5.3 minutes per pass)
The resistances against chipping in this test were evaluated by flank wear.

These results are shown in Tables 6 and 7.

### EXAMPLE 2

The same carbide substrates A through E as EXAMPLE 1 were prepared. The surfaces of the carbide substrates A through E were subjected to honing and chemical vapor deposition using conventional equipment under the conditions shown in Tables 2 or 8 to form hard coating layers having a composition and a designed thickness (at the flank of the cutting insert), wherein each Al₂O₃ (a) through (h) in Table 8 represents an Al₂O₃-based layer, and Al₂O₃ (i) represents an Al₂O₃ layer (the same as in Tables 9 and 10). Coated carbide cutting inserts in accordance with the present invention 11 through 27 and conventional coated carbide cutting inserts 11 through 20 were produced in such a manner.

The resulting coated carbide cutting inserts were subjected to measurement of the maximum thickness of the cutting edge, at which the flank and the rake cross each other, of the Al₂O₃-based layer and the Al₂O₃ layer (in Tables 11 and 12, both are referred to as merely Al₂O₃ layer as the hard coating layer. Further, the thicknesses of these layers at the flank and rake at positions 1 mm from the cutting edge were measured. These results are shown in Tables 11 and 12.

In the hard coated layer, the thicknesses of layers other than both the Al₂O₃ layer and the Al₂O₃-based layer do not have substantial local fluctuations and are identical to the designed thicknesses.

The Al₂O₃-based layer of the cutting insert in accordance with the present invention or the conventional Al₂O₃ layer was subjected to elemental analysis using an EPMA (electron probe micro analyzer). Elemental analysis was carried out based on the same procedure as Example 1.

As a result, the Al₂O₃-based layers of the coated carbide cutting inserts in accordance with the present invention contain 39.9 to 51.9 percent by weight of Al, 46.0 to 46.4 percent by weight of O, 2.1 to 12.9 percent by weight of Ti, and 0.011 to 0.18 percent by weight of Cl, whereas conventional Al₂O₃ layers contain 52.8 to 53.0 percent by weight of Al and 47.0 to 47.2 percent by weight of O, and Ti and Cl were not detected.

Resistances against chipping of coated carbide cutting inserts in accordance with the present invention 11 through 18 and conventional coated carbide cutting inserts 11 through 14 were evaluated by dry continuous and interrupted cutting tests as follows:
Conditions for dry continuous cutting test of alloy steel
   Material to be cut: round bar based on JIS-SCM440
   Cutting speed: 300 m/min.
   Depth of cut: 1.5 mm
   Feed rate: 0.3 mm/rev.
   Cutting time: 15 minutes
Conditions for dry interrupted cutting test of alloy steel
   Material to be cut: round bar based on JIS-SCM440 with four longitudinal grooves equally spaced
   Cutting speed: 150 m/min.
   Depth of cut: 2.0 mm
   Feed rate: 0.3 mm/rev.
   Cutting time: 5 minutes
The resistances against chipping in both tests were evaluated by flank wear.

Resistances against chipping of coated carbide cutting inserts in accordance with the present invention 19 through 23 and conventional coated carbide cutting inserts 15 and 16 were evaluated by dry continuous and interrupted cutting tests as follows:
Conditions for dry continuous cutting test of ductile cast iron
   Material to be cut: round bar based on FCD450
   Cutting speed: 300 m/min.
   Depth of cut: 1.5 mm
   Feed rate: 0.3 mm/rev.
   Cutting time: 15 minutes
Conditions for dry interrupted cutting test of ductile cast iron
   Material to be cut: round bar based on FCD450 with four longitudinal grooves equally spaced
   Cutting speed: 150 m/min.
   Depth of cut: 2.0 mm
   Feed rate: 0.3 mm/rev.
   Cutting time: 5 minutes
The resistances against chipping in both tests were evaluated by flank wear.

Resistances against chipping of coated carbide cutting insert in accordance with the present invention 24 and conventional coated carbide cutting insert 17 were evaluated by dry continuous and interrupted cutting tests as follows:
Conditions for dry continuous cutting test of alloy steel
   Material to be cut: round bar based on JIS-SNCM439
   Cutting speed: 300 m/min.
   Depth of cut: 1.5 mm
   Feed rate: 0.3 mm/rev.
   Cutting time: 15 minutes
Conditions for dry interrupted cutting test of alloy steel
   Material to be cut: round bar based on JIS-SNCM439 with four longitudinal grooves equally spaced
   Cutting speed: 150 m/min.
   Depth of cut: 2.0 mm
   Feed rate: 0.3 mm/rev.
   Cutting time: 5 minutes
The resistances against chipping in both tests were evaluated by flank wear.

Resistances against chipping of coated carbide cutting insert in accordance with the present invention 25 and conventional coated carbide cutting insert 18 were evaluated by dry continuous and interrupted cutting tests as follows:
Conditions for dry continuous cutting test of carbon steel
   Material to be cut: round bar based on JIS-S45C
   Cutting speed: 300 m/min.
   Depth of cut: 1.5 mm
   Feed rate: 0.3 mm/rev.
   Cutting time: 15 minutes
Conditions for dry interrupted cutting test of carbon steel
   Material to be cut: round bar based on JIS-S45C with four longitudinal grooves equally spaced
   Cutting speed: 150 m/min.
   Depth of cut: 2.0 mm
   Feed rate: 0.3 mm/rev.
   Cutting time: 5 minutes
The resistances against chipping in both tests were evaluated by flank wear.

Resistances against chipping of coated carbide cutting insert in accordance with the present invention 26 and conventional coated carbide cutting insert 19 were evaluated by dry continuous and interrupted cutting tests as follows:
Conditions for dry continuous cutting test of cast iron
   Material to be cut: round bar based on JIS-FC300
   Cutting speed: 350 m/min.
   Depth of cut: 1.5 mm
   Feed rate: 0.3 mm/rev.
   Cutting time: 15 minutes
Conditions for dry interrupted cutting test of cast iron
   Material to be cut: round bar based on JIS-FC300 with four longitudinal grooves equally spaced
   Cutting speed: 150 m/min.
   Depth of cut: 2.0 mm
   Feed rate: 0.3 mm/rev.
   Cutting time: 5 minutes
The resistances against chipping in both tests were evaluated by flank wear.

Resistances against chipping of coated carbide cutting insert in accordance with the present invention 27 and conventional coated carbide cutting insert 20 were evaluated by a dry milling test as follows:
Conditions for dry milling test of alloy steel
   Material to be cut: square bar of 100-mm wide and 500-mm long based on JIS-SCM440
   Cutting tool configuration: single cutting insert mounted with a cutter of 125-mm diameter
   Rotation: 510 r.p.m.
   Cutting speed: 200 m/min.
   Depth of cut: 2.0 mm
   Feed rate: 0.2 mm/tooth
   Cutting time: 3 passes (5.3 minutes per pass)
The resistances against chipping in this test were evaluated by flank wear.

These results are shown in Tables 11 and 12.

### EXAMPLE 3

The same carbide substrates A through E as EXAMPLE 1 were prepared. The surfaces of the carbide substrates A through E were subjected to honing and chemical vapor deposition using conventional equipment under the conditions shown in Tables 2 or 13 to form hard coating layers having a composition and a designed thickness (at the flank of the cutting insert), wherein each Al₂O₃ (a) through (i) in Table 13 represents an Al₂O₃-based layer, and Al₂O₃ (j) represents an Al₂O₃ layer (the same as in Tables 14 and 15). Coated carbide cutting inserts in accordance with the present invention 28 through 40 and conventional coated carbide cutting inserts 21 through 30 were produced in such a manner.

The resulting coated carbide cutting inserts were subjected to measurement of the maximum thickness of the cutting edge, at which the flank and the rake cross each other, of the Al₂O₃-based layer and the Al₂O₃ layer (in Tables 16 and 17, both are referred to as merely Al₂O₃ layer as the hard coating layer. Further, the thicknesses of those layers at the flank and rake at positions 1 mm from the cutting edge were measured. These results are shown in Tables 16 and 17.

In the hard coated layer, the thicknesses of layers other than both the Al₂O₃ layer and the Al₂O₃-based layer do not have substantial local fluctuations and are identical to the designed thicknesses.

The Al₂O₃-based layer of the cutting insert in accordance with the present invention or the conventional Al₂O₃ layer was subjected to elemental analysis using an EPMA (electron probe micro analyzer). Elemental analysis was carried out by the same procedure as Example 1.

As a result, the Al₂O₃-based layers of the coated carbide cutting inserts in accordance with the present invention contain 41.1 to 52.1 percent by weight of Al, 46.3 to 46.2 percent by weight of O, 0.35 to 9.1 percent by weight of Zr, 0.42 to 10.4 percent by weight of Hf, and 0.014 to 0.15 percent by weight of Cl, whereas conventional Al₂O₃ layers contain 52.8 to 53.0 percent by weight of Al and 47.0 to 47.2 percent by weight of O, and Zr, Hf and Cl were not detected.

Resistances against chipping of coated carbide cutting inserts in accordance with the present invention 28 through 32 and conventional coated carbide cutting inserts 21 and 22 were evaluated by dry continuous and interrupted cutting tests as follows:
Conditions for dry continuous cutting test of ductile cast iron
   Material to be cut: round bar based on JIS-FCD700
   Cutting speed: 300 m/min.
   Depth of cut: 1.5 mm
   Feed rate: 0.3 mm/rev.
   Cutting time: 15 minutes
Conditions for dry interrupted cutting test of ductile cast iron
   Material to be cut: round bar based on JIS-FCD700 with four longitudinal grooves equally spaced
   Cutting speed: 150 m/min.
   Depth of cut: 2.0 mm
   Feed rate: 0.3 mm/rev.
   Cutting time: 5 minutes
The resistances against chipping in both tests were evaluated by flank wear.

Resistances against chipping of coated carbide cutting inserts in accordance with the present invention 33 and 34 and conventional coated carbide cutting inserts 23 and 24 were evaluated by dry continuous and interrupted cutting tests as follows:
Conditions for dry continuous cutting test of alloy steel
   Material to be cut: round bar based on JIS-SCM440
   Cutting speed: 300 m/min.
   Depth of cut: 1.5 mm
   Feed rate: 0.3 mm/rev.
   Cutting time: 15 minutes
Conditions for dry interrupted cutting test of alloy steel
   Material to be cut: round bar based on JIS-SCM440 with four longitudinal grooves equally spaced
   Cutting speed: 150 m/min.
   Depth of cut: 2.0 mm
   Feed rate: 0.3 mm/rev.
   Cutting time: 5 minutes
The resistances against chipping in both tests were evaluated by flank wear.

Resistances against chipping of coated carbide cutting inserts in accordance with the present invention 35 and 36 and conventional coated carbide cutting inserts 25 and 26 were evaluated by dry continuous and interrupted cutting tests as follows:
Conditions for dry continuous cutting test of carbon steel
   Material to be cut: round bar based on JIS-S30C
   Cutting speed: 300 m/min.
   Depth of cut: 1.5 mm
   Feed rate: 0.3 mm/rev.
   Cutting time: 15 minutes
Conditions for dry interrupted cutting test of carbon steel
   Material to be cut: round bar based on JIS-S30C with four longitudinal grooves equally spaced
   Cutting speed: 150 m/min.
   Depth of cut: 2.0 mm
   Feed rate: 0.3 mm/rev.
   Cutting time: 5 minutes
The resistances against chipping in both tests were evaluated by flank wear.

Resistances against chipping of coated carbide cutting inserts in accordance with the present invention 37 and 38 and conventional coated carbide cutting inserts 27 and 28 were evaluated by dry continuous and interrupted cutting tests as follows:
Conditions for dry continuous cutting test of cast iron
   Material to be cut: round bar based on JIS-FC200
   Cutting speed: 350 m/min.
   Depth of cut: 1.5 mm
   Feed rate: 0.3 mm/rev.
   Cutting time: 15 minutes
Conditions for dry interrupted cutting test of cast iron
   Material to be cut: round bar based on JIS-FC200 with four longitudinal grooves equally spaced
   Cutting speed: 150 m/min.
   Depth of cut: 2.0 mm
   Feed rate: 0.3 mm/rev.
   Cutting time: 5 minutes
The resistances against chipping in both tests were evaluated by flank wear.

Resistances against chipping of coated carbide cutting inserts in accordance with the present invention 39 and 40 and conventional coated carbide cutting inserts 29 and 30 were evaluated by a dry continual test as follows:
Conditions for dry milling test of alloy steel
   Material to be cut: square bar of 100-mm wide and 500-mm long based on JIS-SCM440
   Cutting tool configuration: single cutting insert mounted with a cutter of 125-mm diameter
   Rotation: 510 r.p.m.
   Cutting speed: 200 m/min.
   Depth of cut: 2.0 mm
   Feed rate: 0.2 mm/tooth
   Cutting time: 3 passes (5.3 minutes per pass)
The resistances against chipping in this test were evaluated by flank wear.

These results are shown in Tables 16 and 17.

### EXAMPLE 4

The same carbide substrates A through E as EXAMPLE 1 were prepared. The surfaces of the carbide substrates A through E were subjected to honing and chemical vapor deposition using conventional equipment under the conditions shown in Tables 2 or 18 to form hard coating layers having a composition and a designed thickness (at the flank of the cutting insert), wherein l-TiCN in Table 2 represents TiCN having a crystal structure longitudinally grown described in Japanese Unexamined Patent Publication No. 6-8010, p-TiCN in the same table represents TiCN having a general crystal grain structure, each Al₂O₃ (a) through (k) in Table 18 represents an Al₂O₃-based layer, and Al₂O₃ (l) represents an Al₂O₃ layer (the same as in Tables 19 and 20). Coated carbide cutting inserts in accordance with the present invention 41 through 57 and conventional coated carbide cutting inserts 31 through 40 were produced in such a manner.

The resulting coated carbide cutting inserts were subjected to measurement of the maximum thickness of the cutting edge, at which the flank and the rake cross each other, of the Al₂O₃-based layer and the Al₂O₃ layer (in Tables 21 and 22, both are referred to as merely Al₂O₃ layer as the hard coating layer. Further, the thicknesses of the flank and rake at positions 1 mm from the cutting edge were measured. These results are shown in Tables 21 and 22.

In the hard coated layer, the thicknesses of the Al₂O₃ based layer and layers other than the Al₂O₃ layer do not have substantial local fluctuations and are identical to the designed thicknesses.

The Al₂O₃-based layer of the cutting insert in accordance with the present invention or the conventional Al₂O₃ layer was subjected to elemental analysis using an EPMA (electron probe micro analyzer). Elemental analysis was carried out by the same procedure as Example 1.

As a result, the Al₂O₃-based layers of the coated carbide cutting inserts in accordance with the present invention contain 39.1 to 50.7 percent by weight of Al, 44.9 to 46.3 percent by weight of O, 1.9 to 13.6 percent by weight of Ti, 0.14 to 0.20 percent by weight of Cl, 0.3 to 8.5 percent by weight of Zr, and 0.3 to 9.6 percent by weight of Hf, whereas conventional Al₂O₃ layers contain 52.8 to 53.0 percent by weight of Al and 47.0 to 47.2 percent by weight of O, and Ti, Cl, Zr and Hf were not detected.

Resistances against chipping of coated carbide cutting inserts in accordance with the present invention 41 through 49 and conventional coated carbide cutting inserts 31 and 36 were evaluated by dry continuous and interrupted cutting tests as follows:
Conditions for dry continuous cutting test of ductile cast iron
   Material to be cut: round bar based on JIS-FCD700
   Cutting speed: 300 m/min.
   Depth of cut: 1.5 mm
   Feed rate: 0.3 mm/rev.
   Cutting time: 15 minutes
Conditions for dry interrupted cutting test of ductile cast iron
   Material to be cut: round bar based on JIS-FCD700 with four longitudinal grooves equally spaced
   Cutting speed: 150 m/min.
   Depth of cut: 2.0 mm
   Feed rate: 0.3 mm/rev.
   Cutting time: 5 minutes
The resistances against chipping in both tests were evaluated by flank wear.

Resistances against chipping of coated carbide cutting inserts in accordance with the present invention 50 and 51 and conventional coated carbide cutting insert 37 were evaluated by dry continuous and interrupted cutting tests as follows:
Conditions for dry continuous cutting test of alloy steel
   Material to be cut: round bar based on JIS-SCM439
   Cutting speed: 300 m/min.
   Depth of cut: 1.5 mm
   Feed rate: 0.3 mm/rev.
   Cutting time: 15 minutes
Conditions for dry interrupted cutting test of alloy steel
   Material to be cut: round bar based on JIS-SCM439 with four longitudinal grooves equally spaced
   Cutting speed: 150 m/min.
   Depth of cut: 2.0 mm
   Feed rate: 0.3 mm/rev.
   Cutting time: 5 minutes
The resistances against chipping in both tests were evaluated by flank wear.

Resistances against chipping of coated carbide cutting inserts in accordance with the present invention 52 and 53 and conventional coated carbide cutting insert 38 were evaluated by dry continuous and interrupted cutting tests as follows:
Conditions for dry continuous cutting test of carbon steel
   Material to be cut: round bar based on JIS-S45C
   Cutting speed: 300 m/min.
   Depth of cut: 1.5 mm
   Feed rate: 0.3 mm/rev.
   Cutting time: 15 minutes
Conditions for dry interrupted cutting test of carbon steel
   Material to be cut: round bar based on JIS-S45C with four longitudinal grooves equally spaced
   Cutting speed: 150 m/min.
   Depth of cut: 2.0 mm
   Feed rate: 0.3 mm/rev.
   Cutting time: 5 minutes
The resistances against chipping in both tests were evaluated by flank wear.

Resistances against chipping of coated carbide cutting inserts in accordance with the present invention 54 and 55 and conventional coated carbide cutting insert 39 were evaluated by dry continuous and interrupted cutting tests as follows:
Conditions for dry continuous cutting test of cast iron
   Material to be cut: round bar based on JIS-FC200
   Cutting speed: 350 m/min.
   Depth of cut: 1.5 mm
   Feed rate: 0.3 mm/rev.
   Cutting time: 15 minutes
Conditions for dry interrupted cutting test of cast iron
   Material to be cut: round bar based on JIS-FC200 with four longitudinal grooves equally spaced
   Cutting speed: 150 m/min.
   Depth of cut: 2.0 mm
   Feed rate: 0.3 mm/rev.
   Cutting time: 5 minutes
The resistances against chipping in both tests were evaluated by flank wear.

Resistances against chipping of coated carbide cutting inserts in accordance with the present invention 56 and 57 and conventional coated carbide cutting insert 40 were evaluated by a dry continual test as follows:
Conditions for dry milling test of alloy steel
   Material to be cut: square bar of 100-mm wide and 500-mm long based on JIS-SCM440
   Cutting tool configuration: single cutting insert mounted with a cutter of 125-mm diameter
   Rotation: 510 r.p.m.
   Cutting speed: 200 m/min.
   Depth of cut: 2.0 mm
   Feed rate: 0.2 mm/tooth
   Cutting time: 3 passes (5.3 minutes per pass)
The resistances against chipping in this test were evaluated by flank wear.

These results are shown in Tables 21 and 22.

As set forth above, a coated carbide cutting member in accordance with the present invention has hard coating layers comprising an Al₂O₃-based layer in which Cl is included using a reactive gas diluted with an inert gas, and the Al₂O₃-based layer has a fine crystalline structure. In contrast, since a conventional coated carbide cutting member uses a hydrogen-base reactive gas to form the Al₂O₃ coating layer, the resulting Al₂O₃ layer has a coarse crystalline structure, and the thicknesses of the flank, rake and edge fluctuate significantly. Thus, the coated carbide cutting member in accordance with the present invention exhibits excellent wear resistance to continuous cutting of steel and cast iron and significantly excellent resistance against chipping to interrupted cutting, without the loosing excellent characteristics of the Al₂O₃ layer.

In particular, the local fluctuation of the thickness of the Al₂O₃-based layer is extremely low in the coated carbide cutting member in accordance with the present invention even when the Al₂O₃-based layer is thickened. Thus, the coated carbide cutting member exhibits significantly improved resistance against chipping to continuous and interrupted cutting of, for example, steel and cast iron, and exhibits excellent cutting characteristics for long terms. Such advantages contribute to factory automation and labor saving in relation to cutting operations.

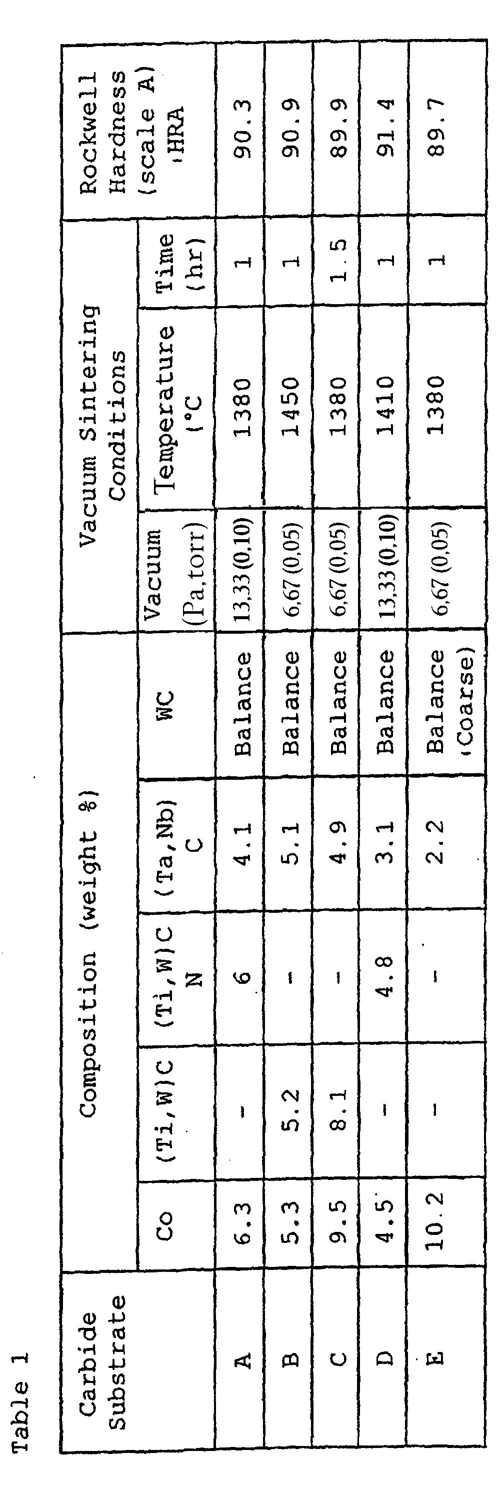

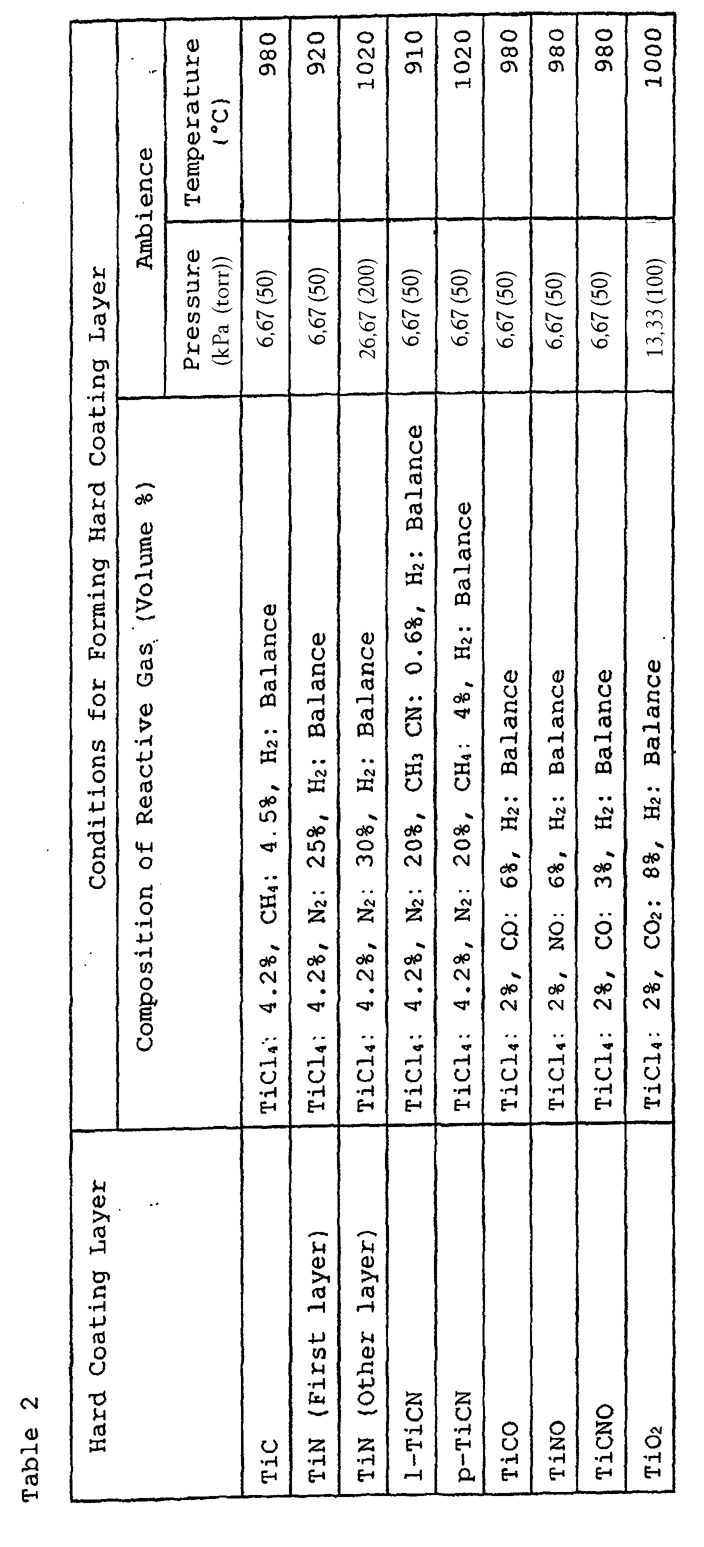

>

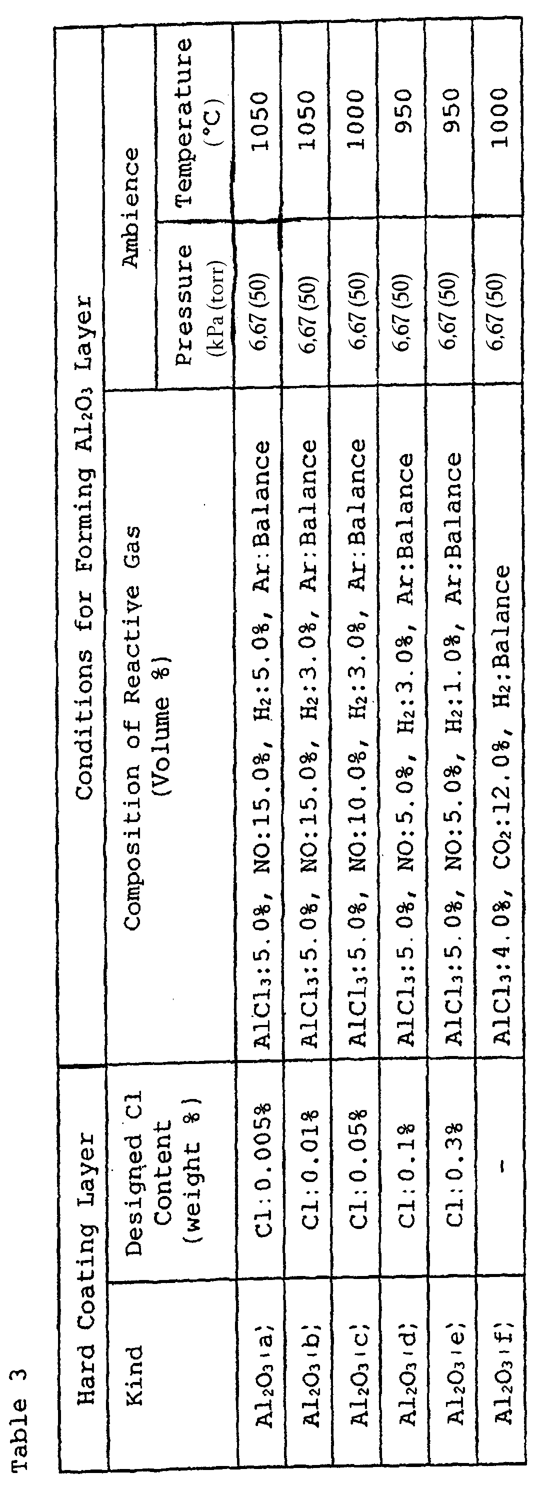

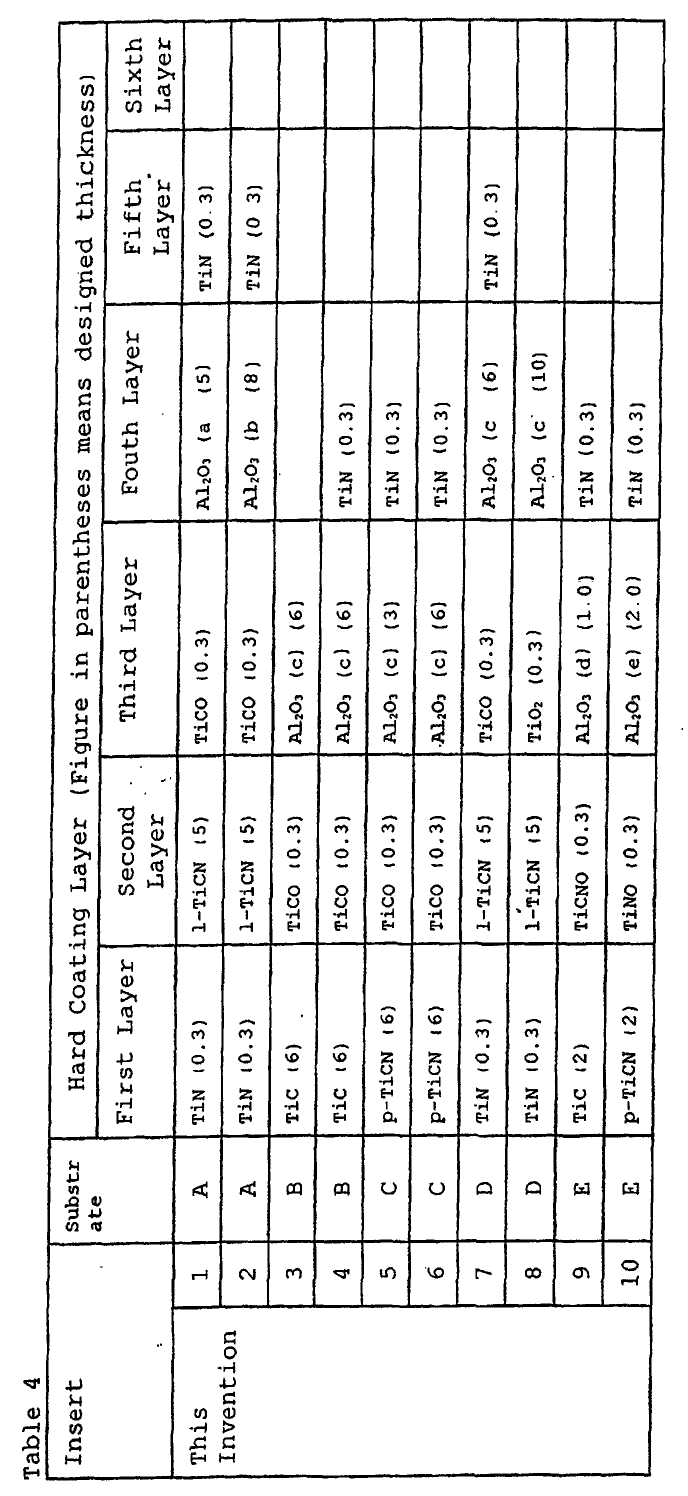

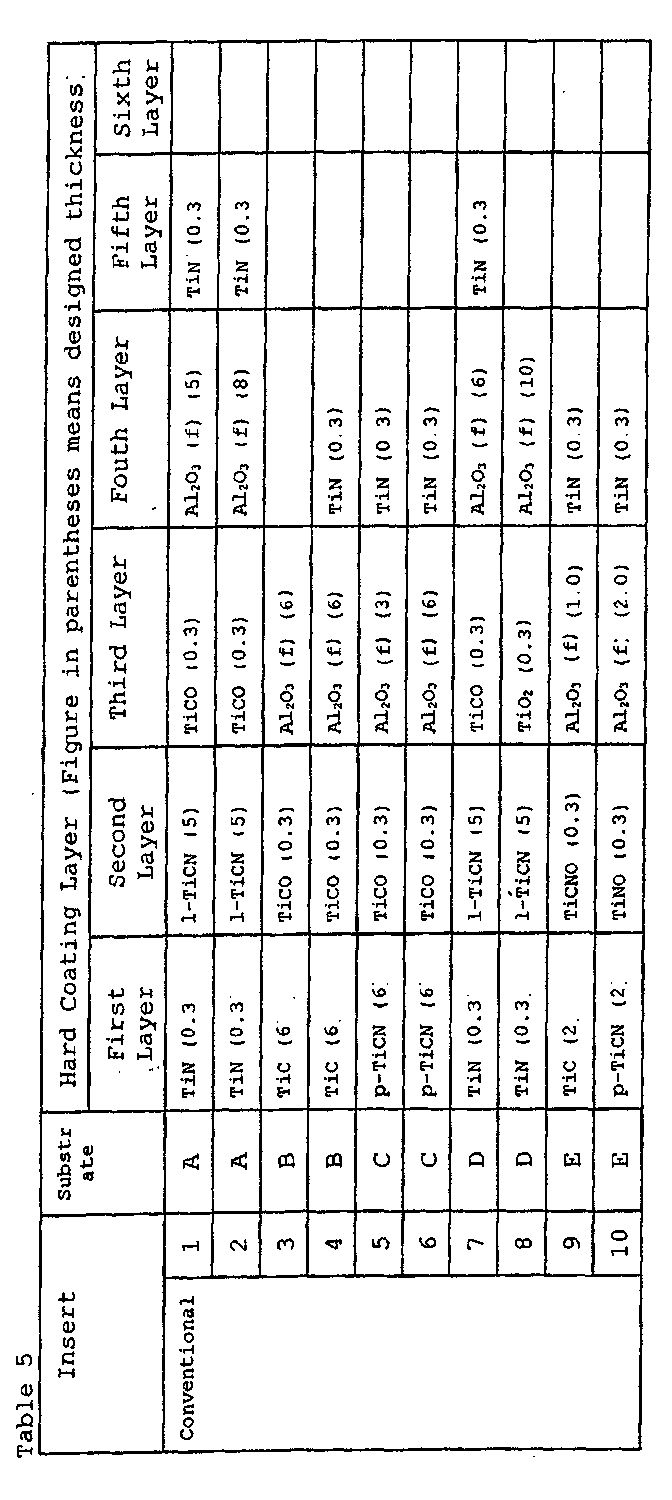

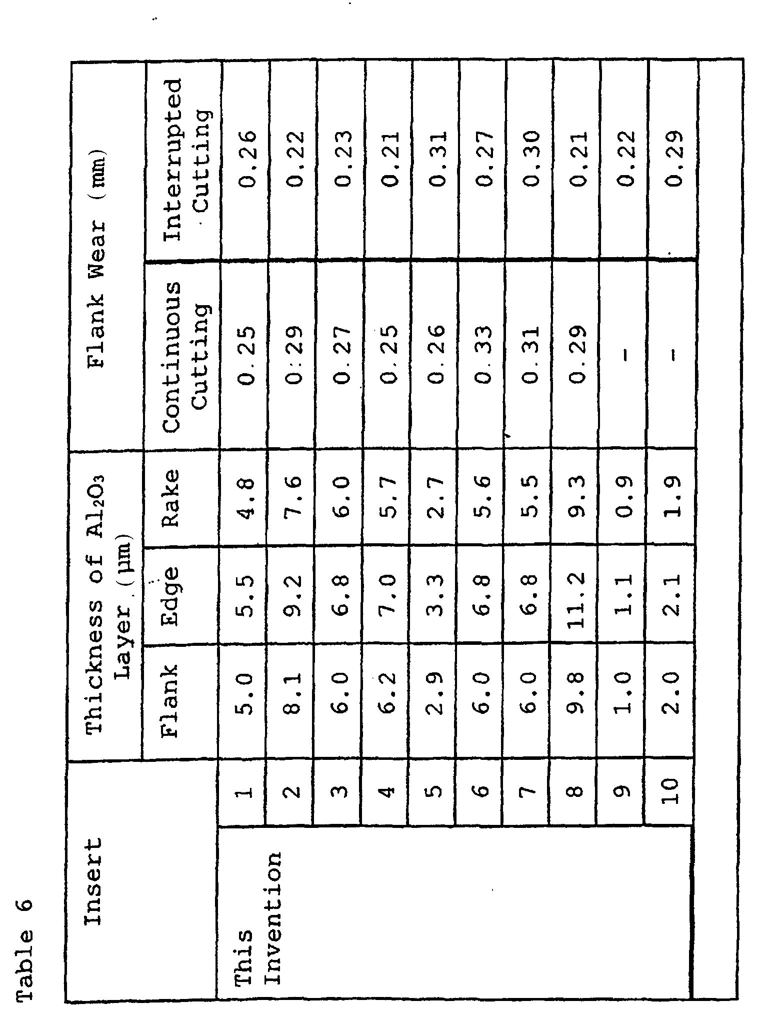

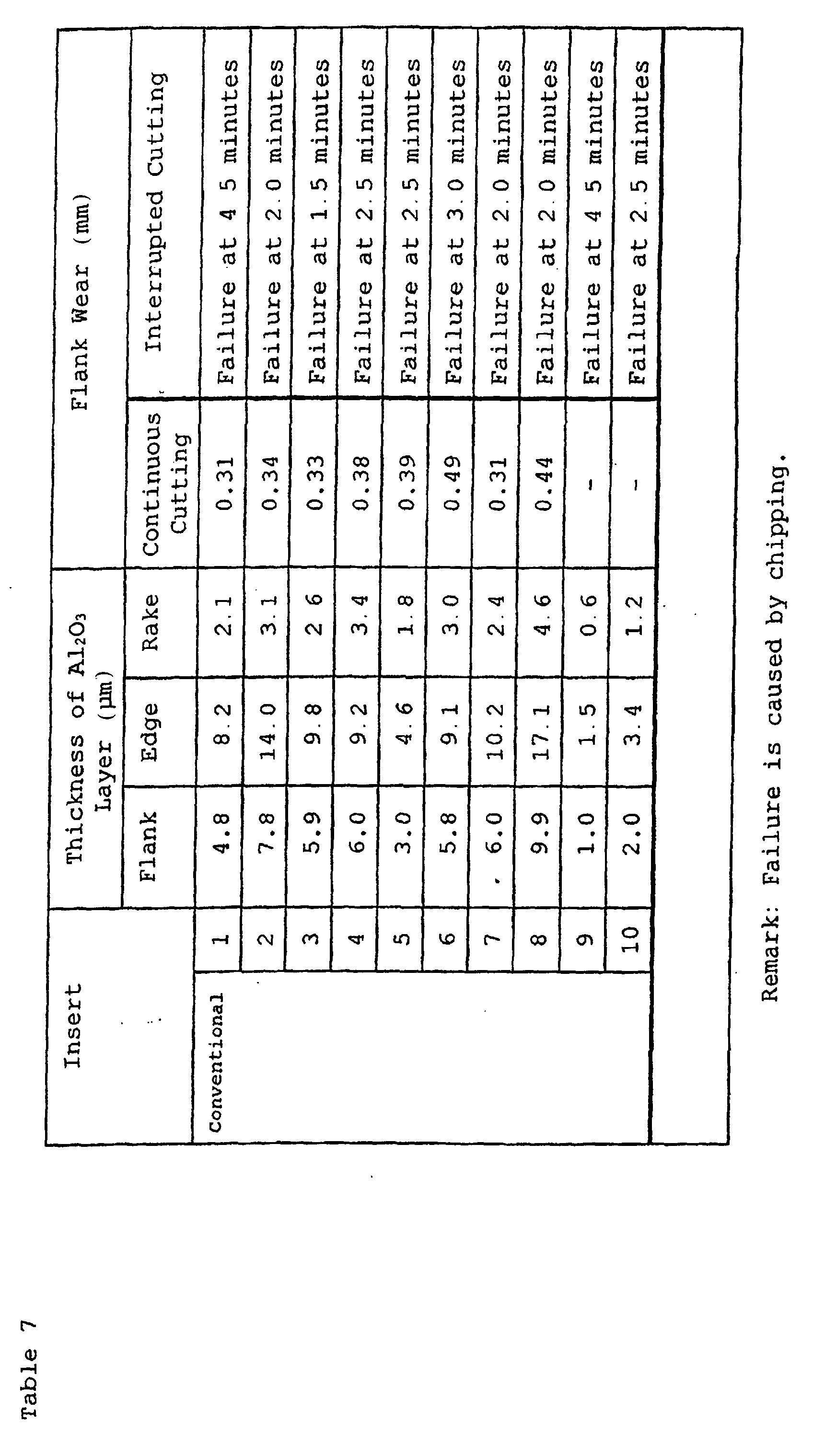

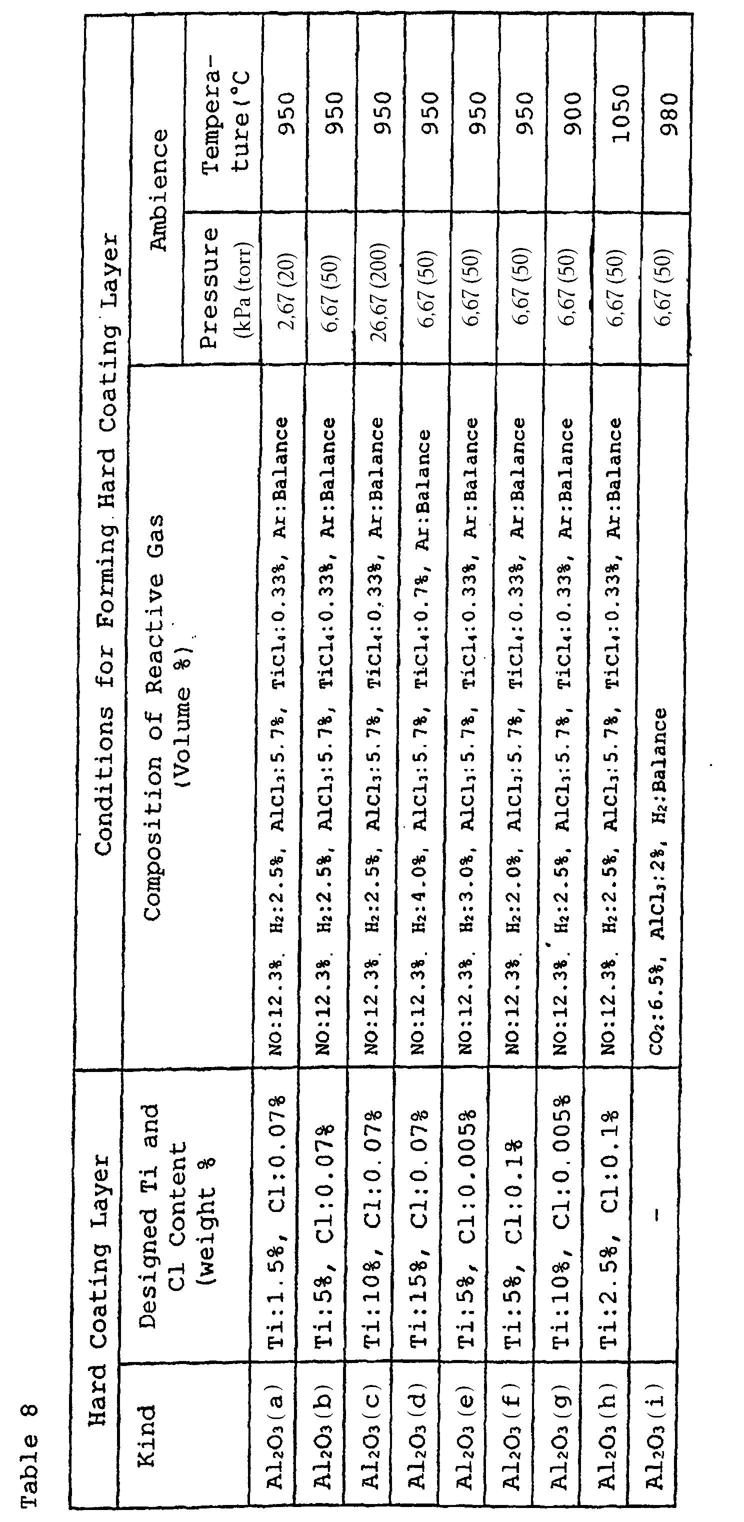

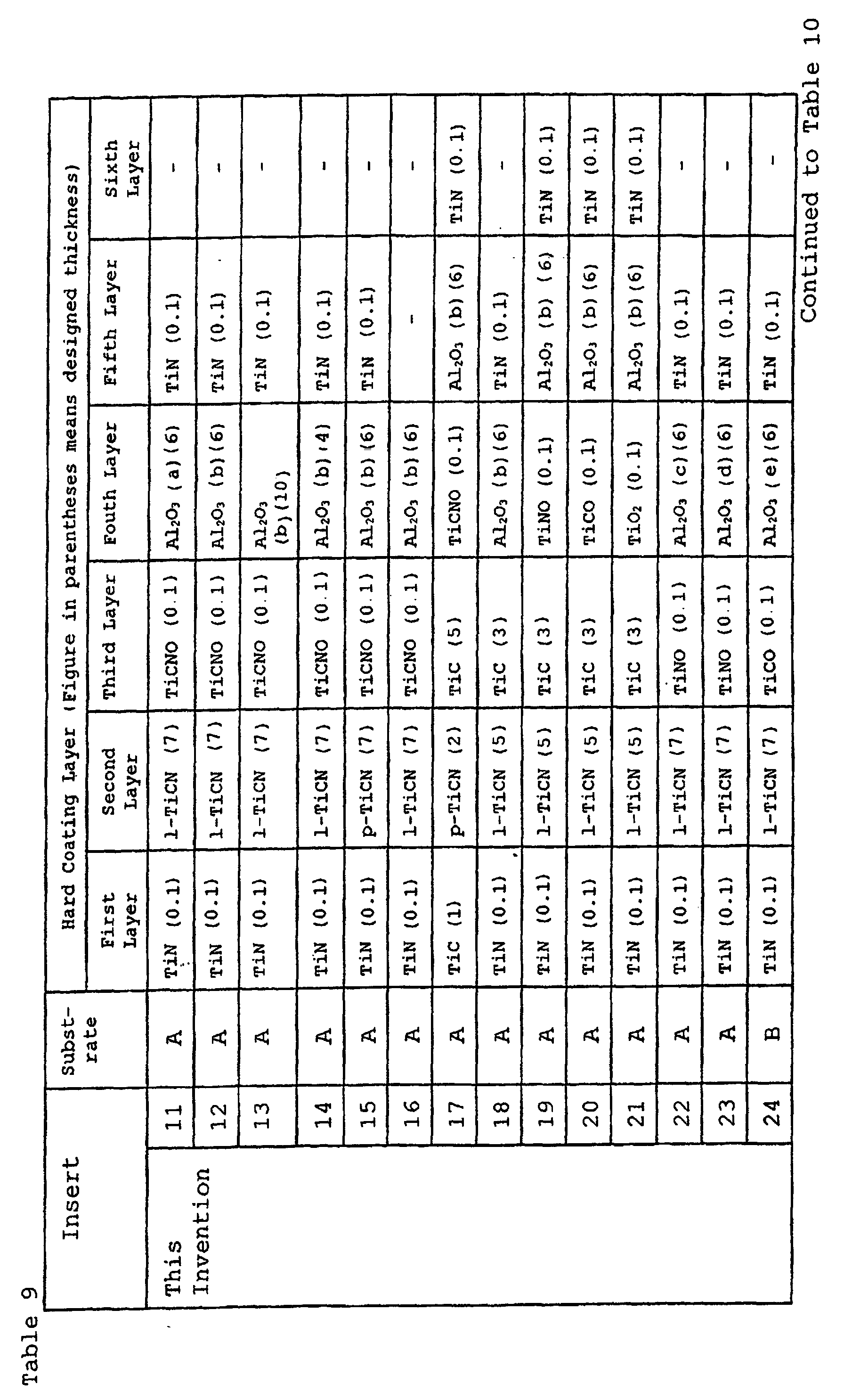

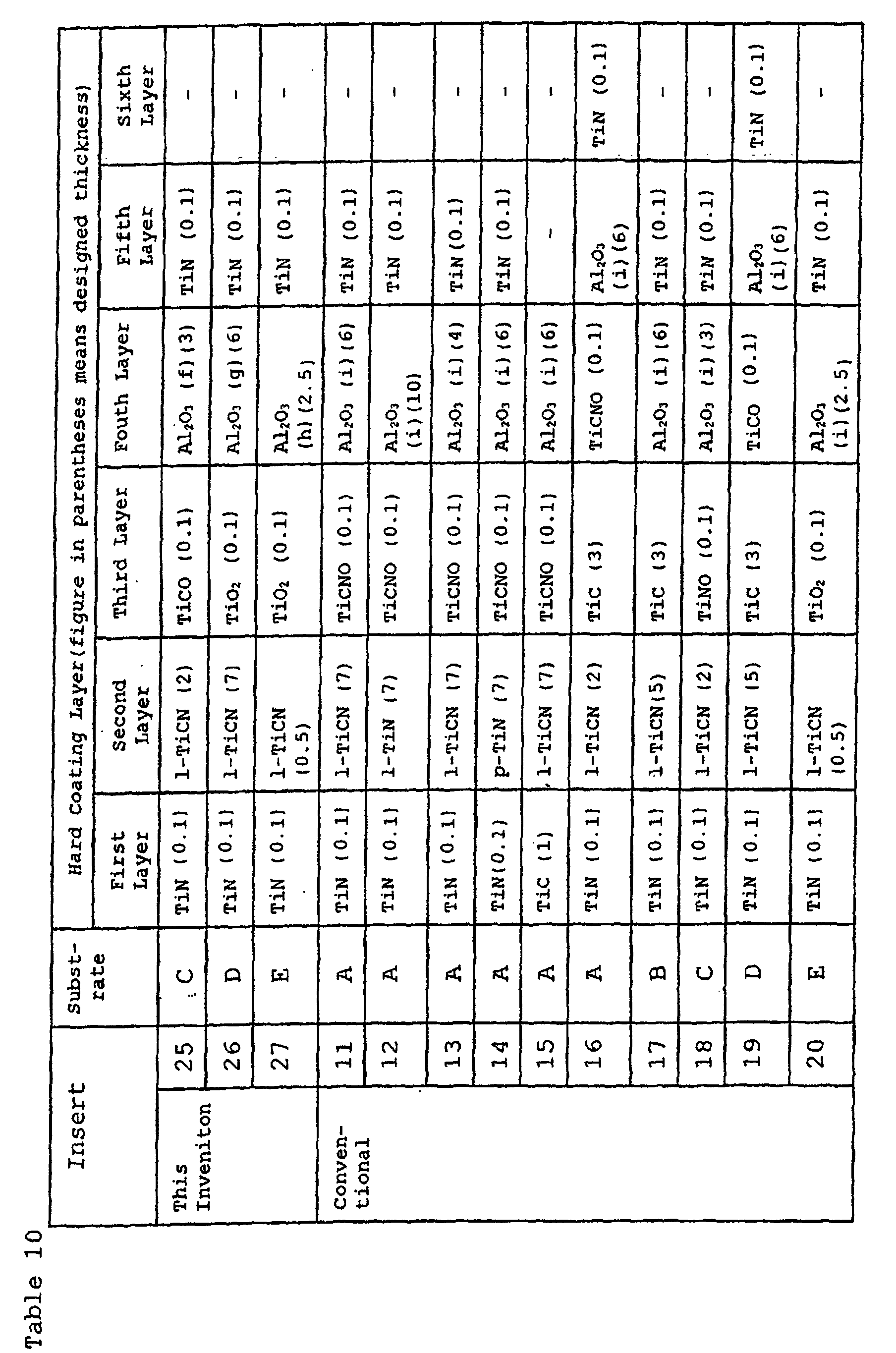

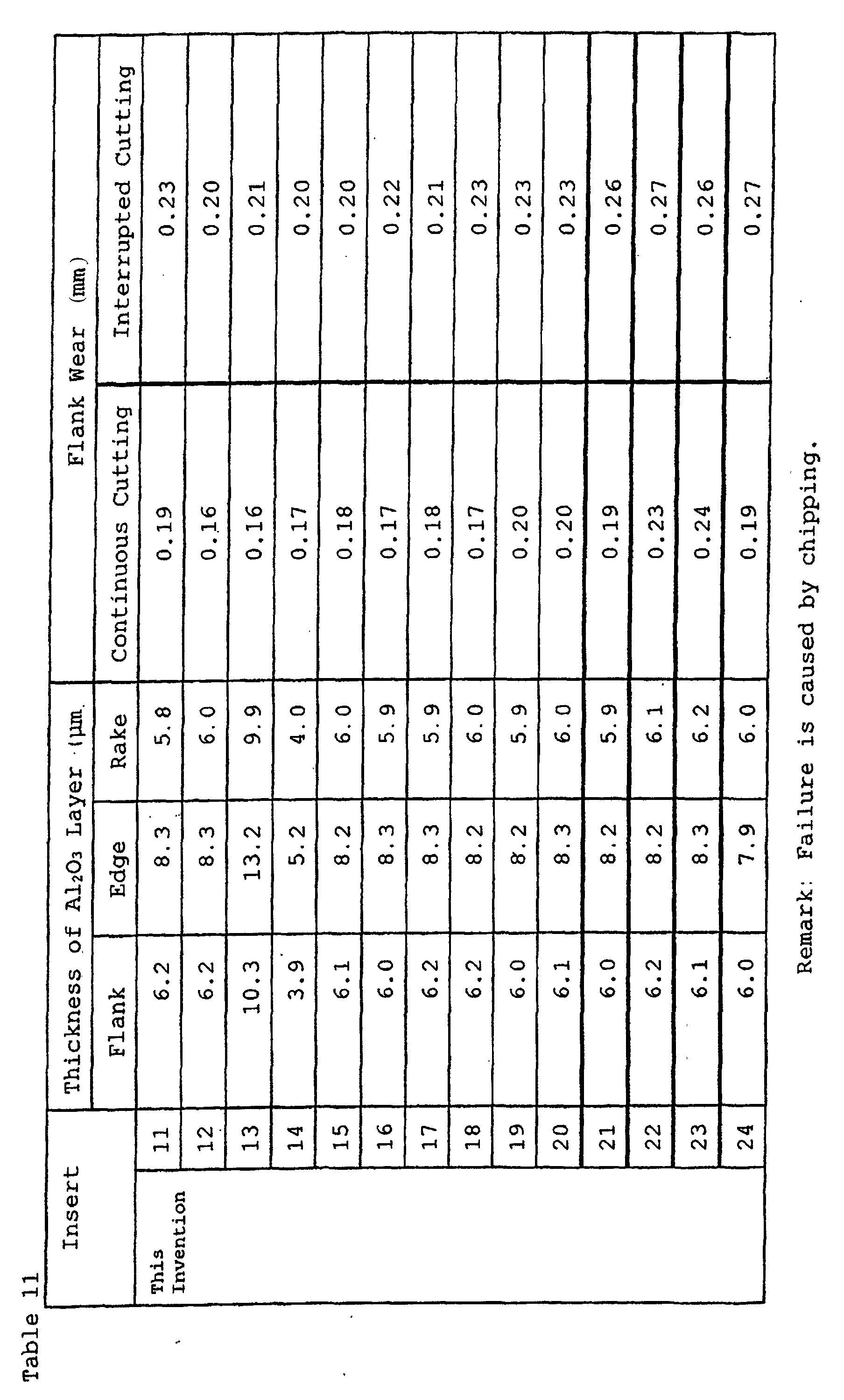

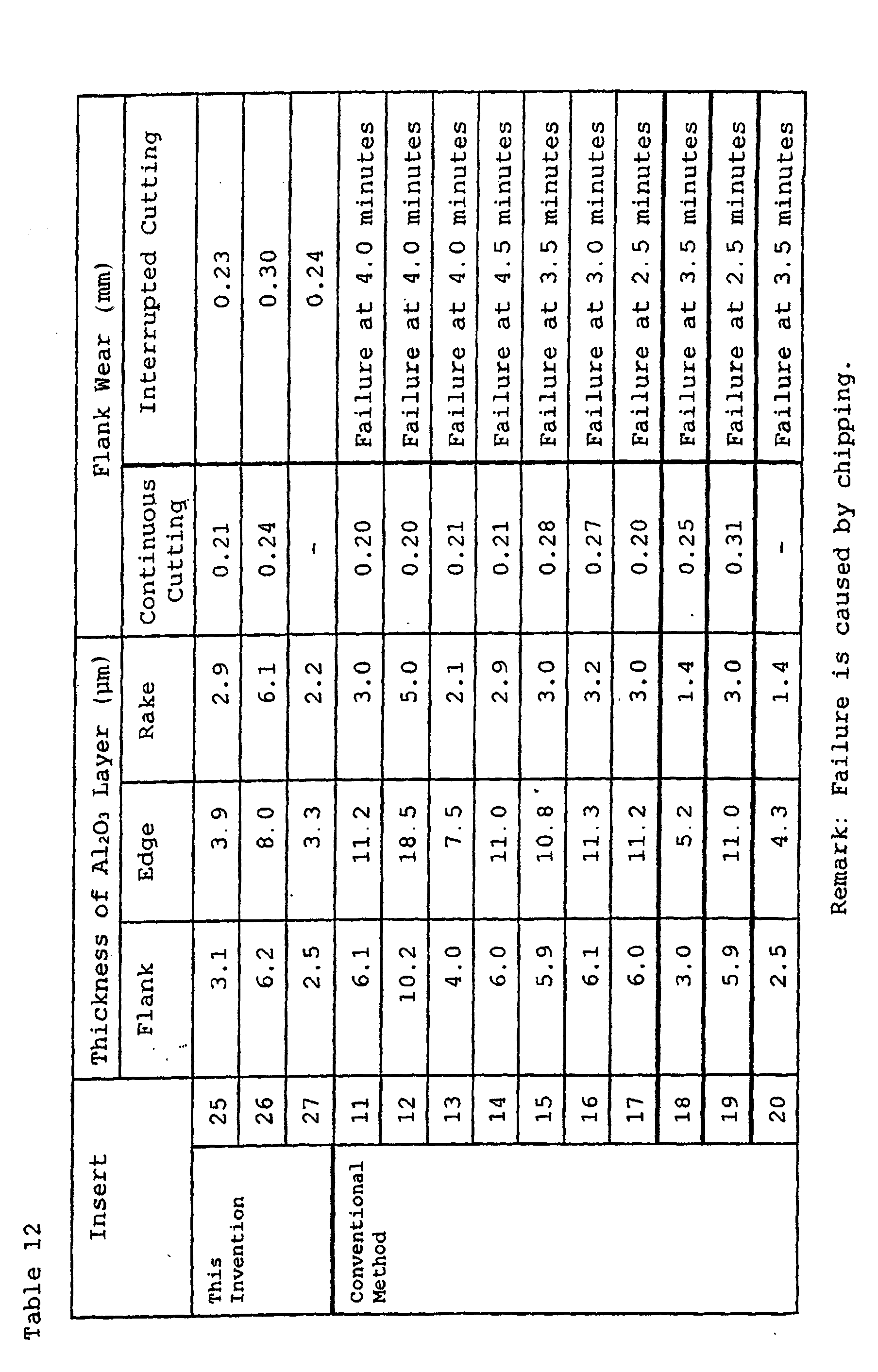

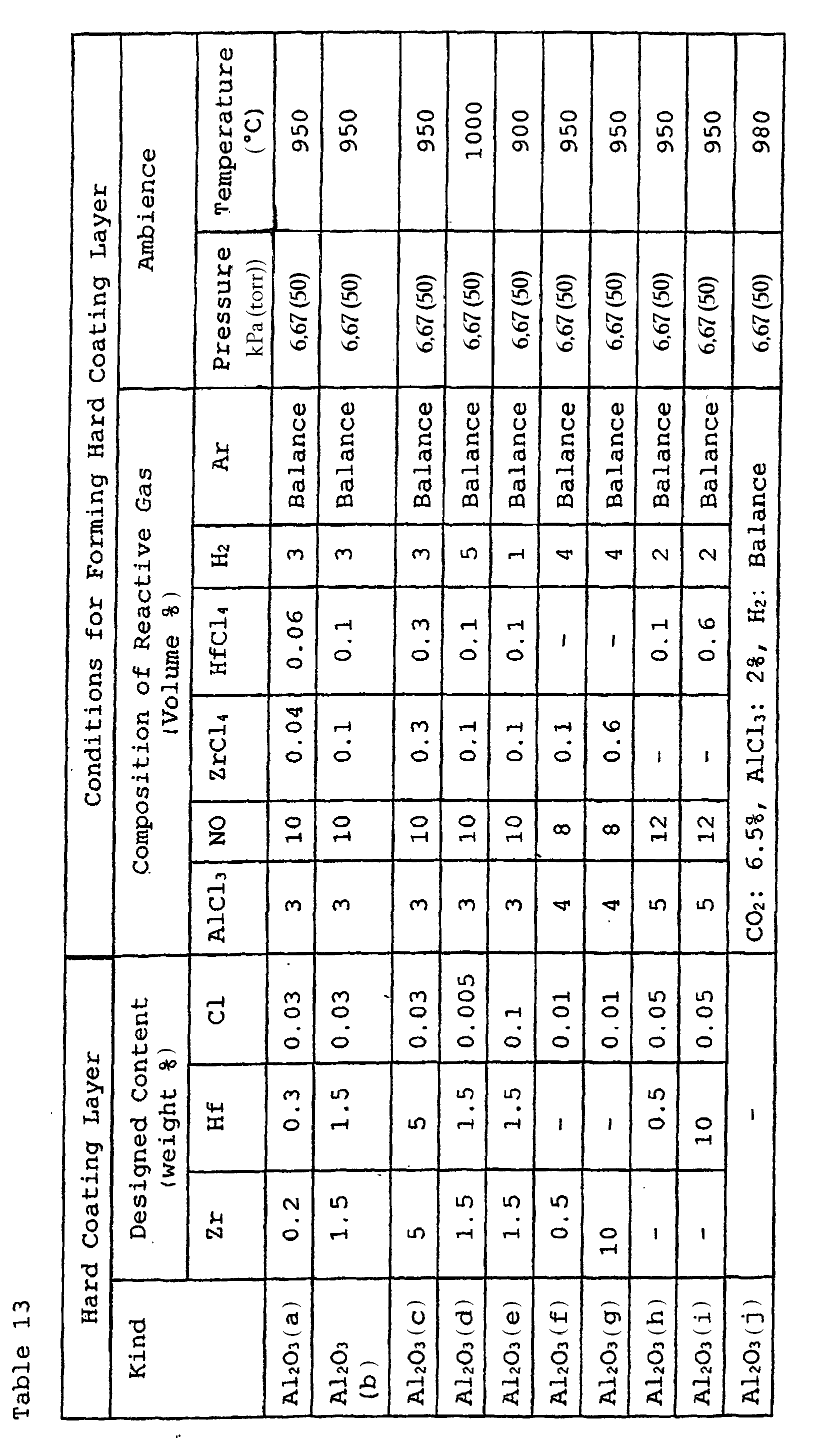

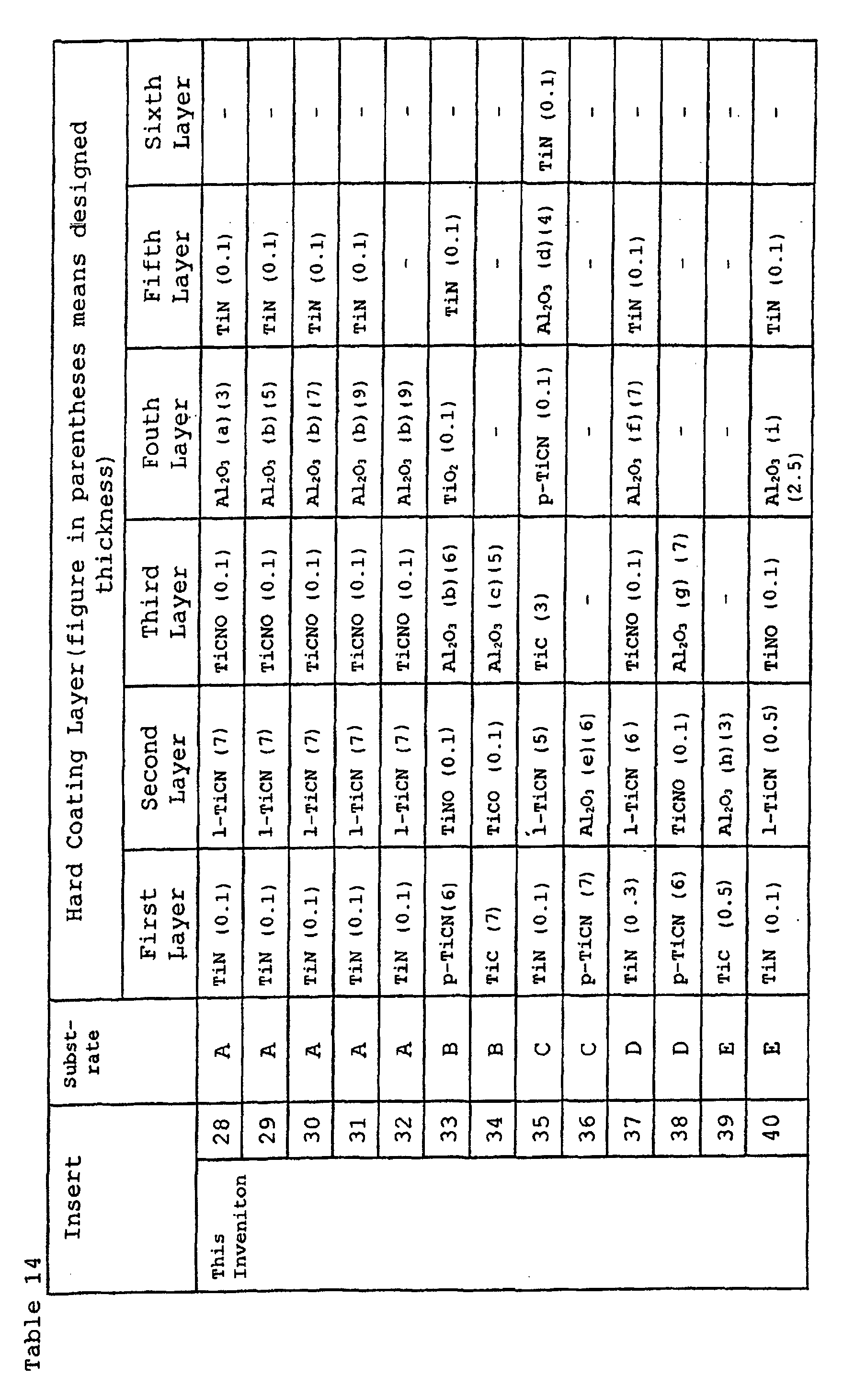

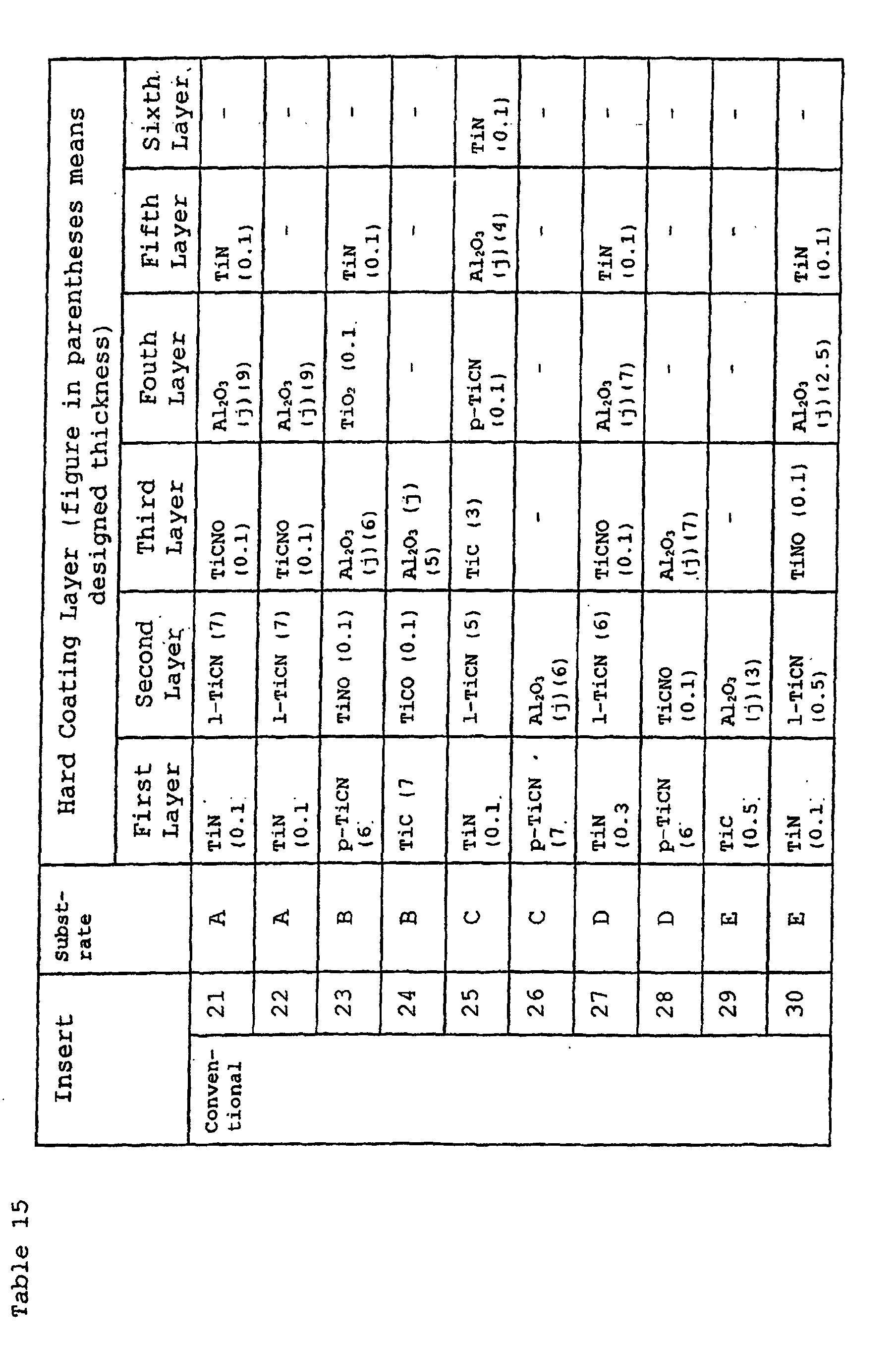

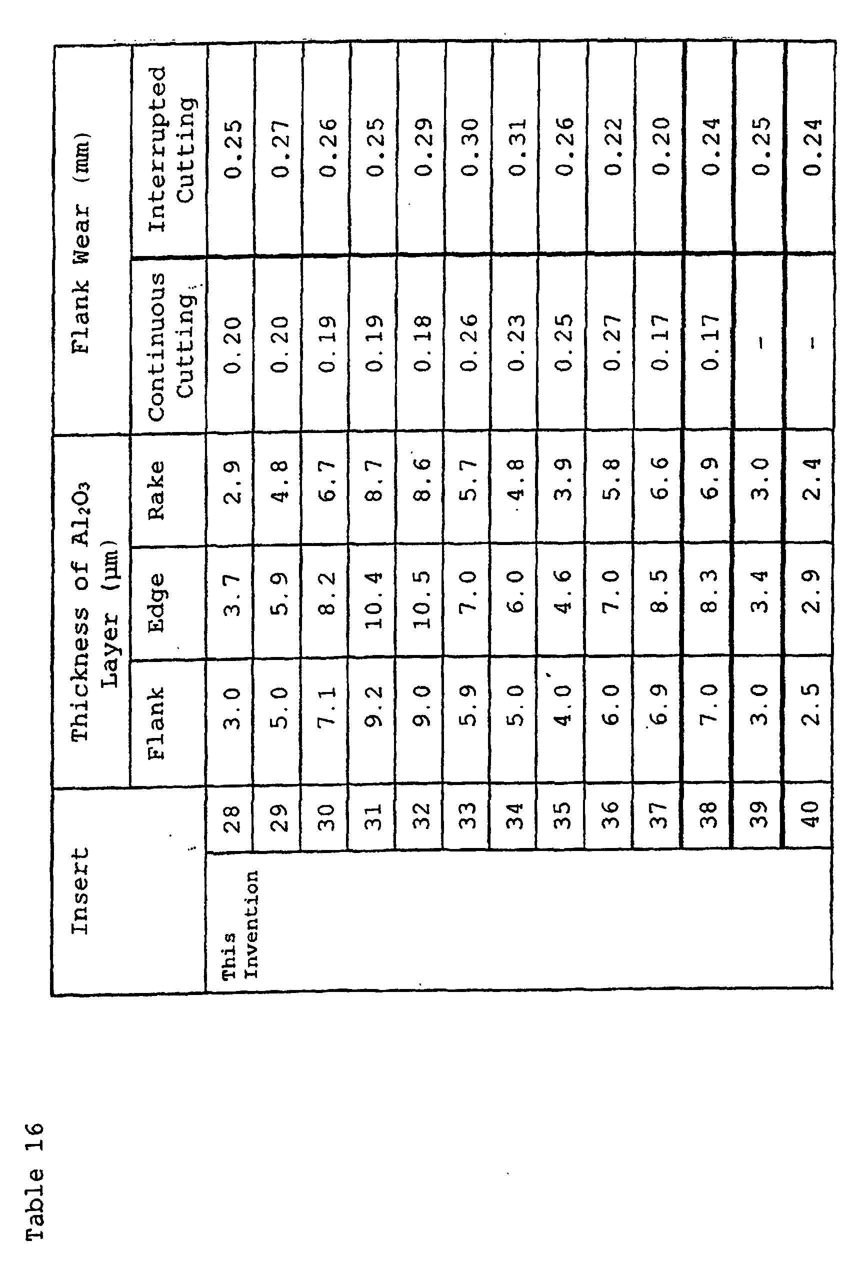

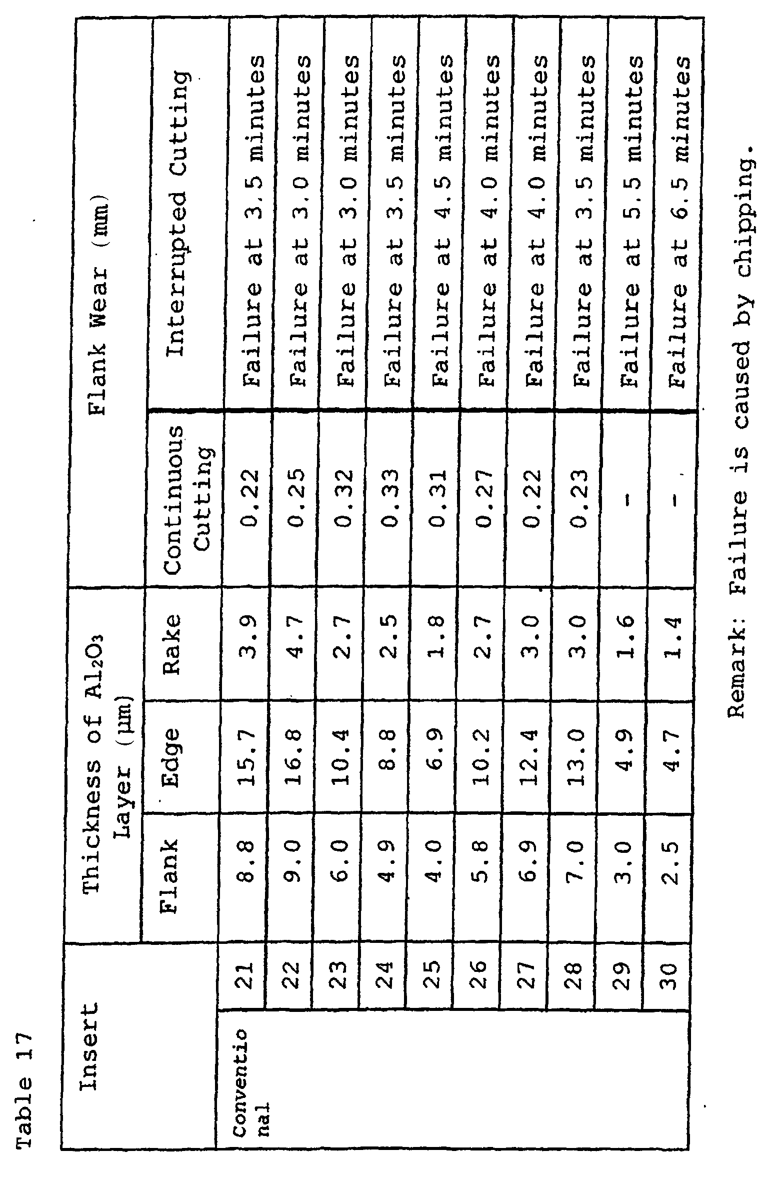

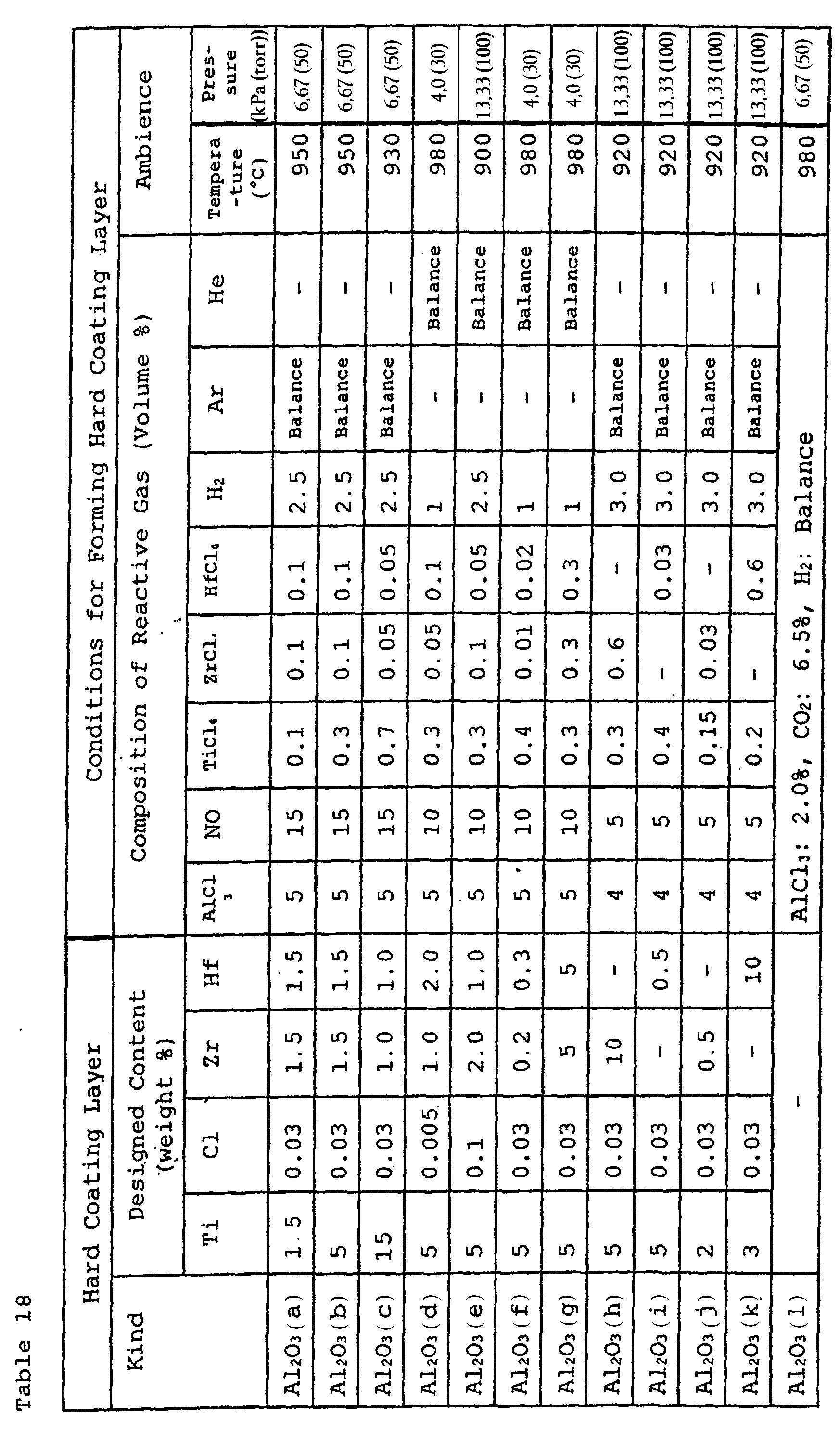

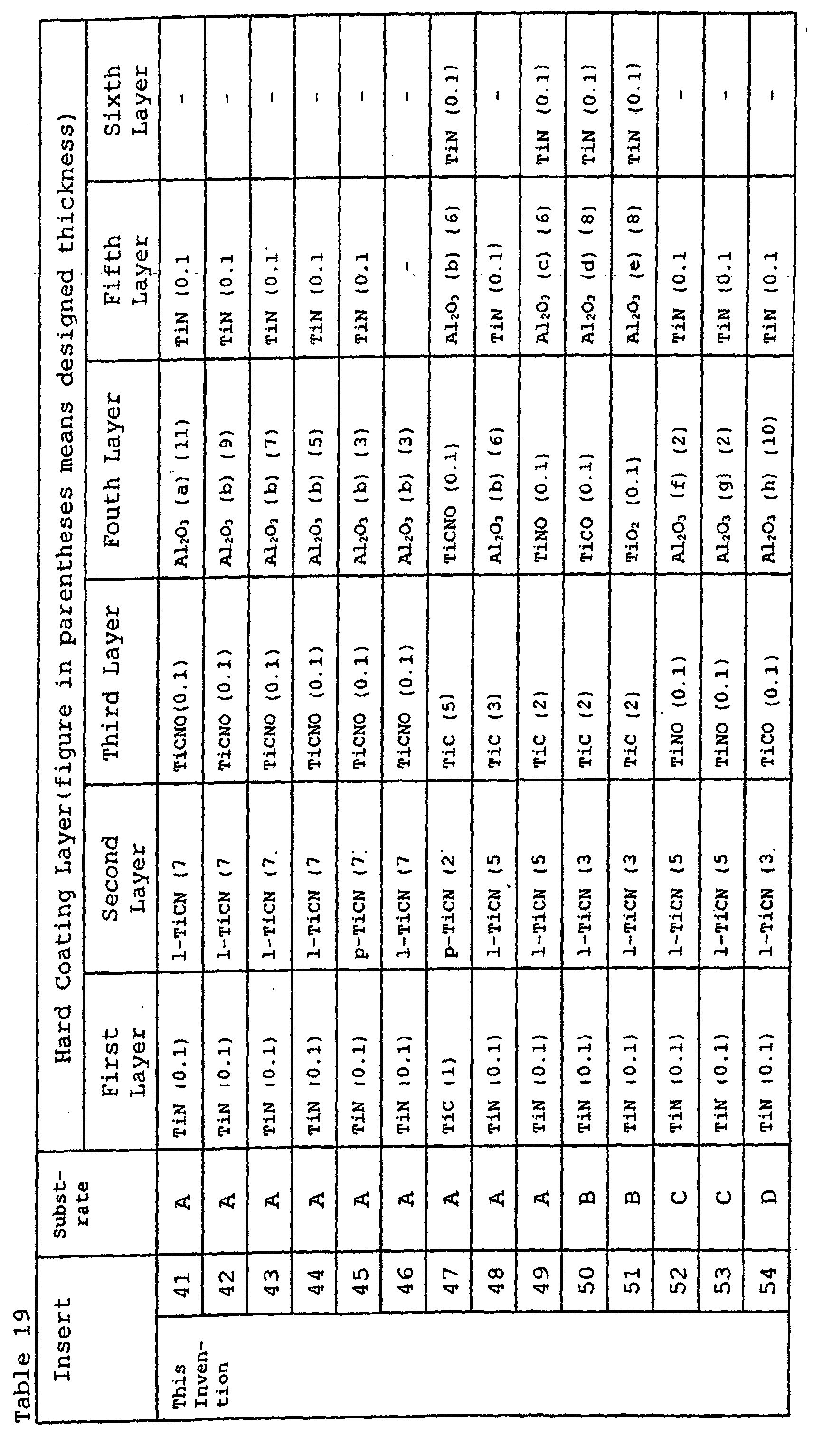

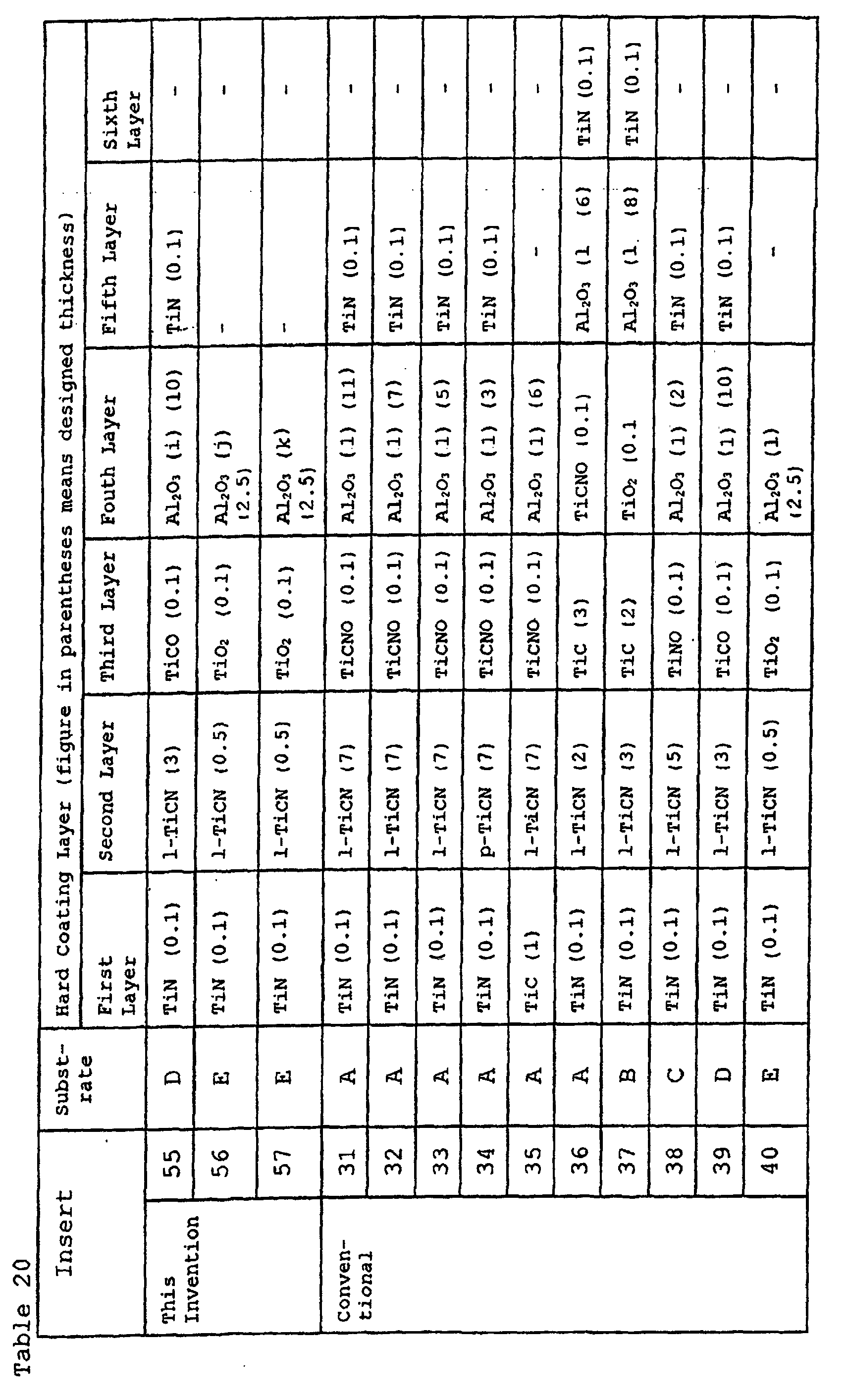

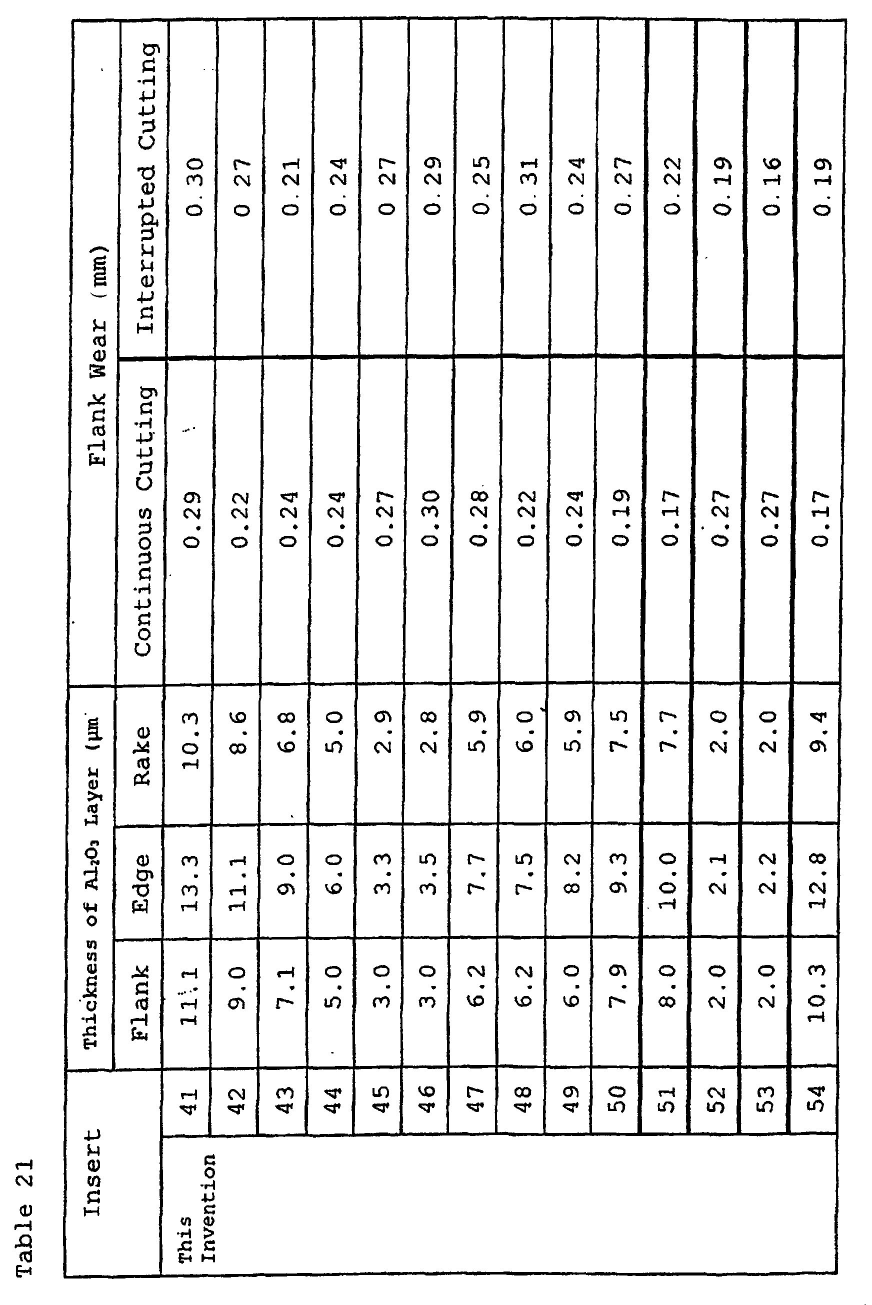

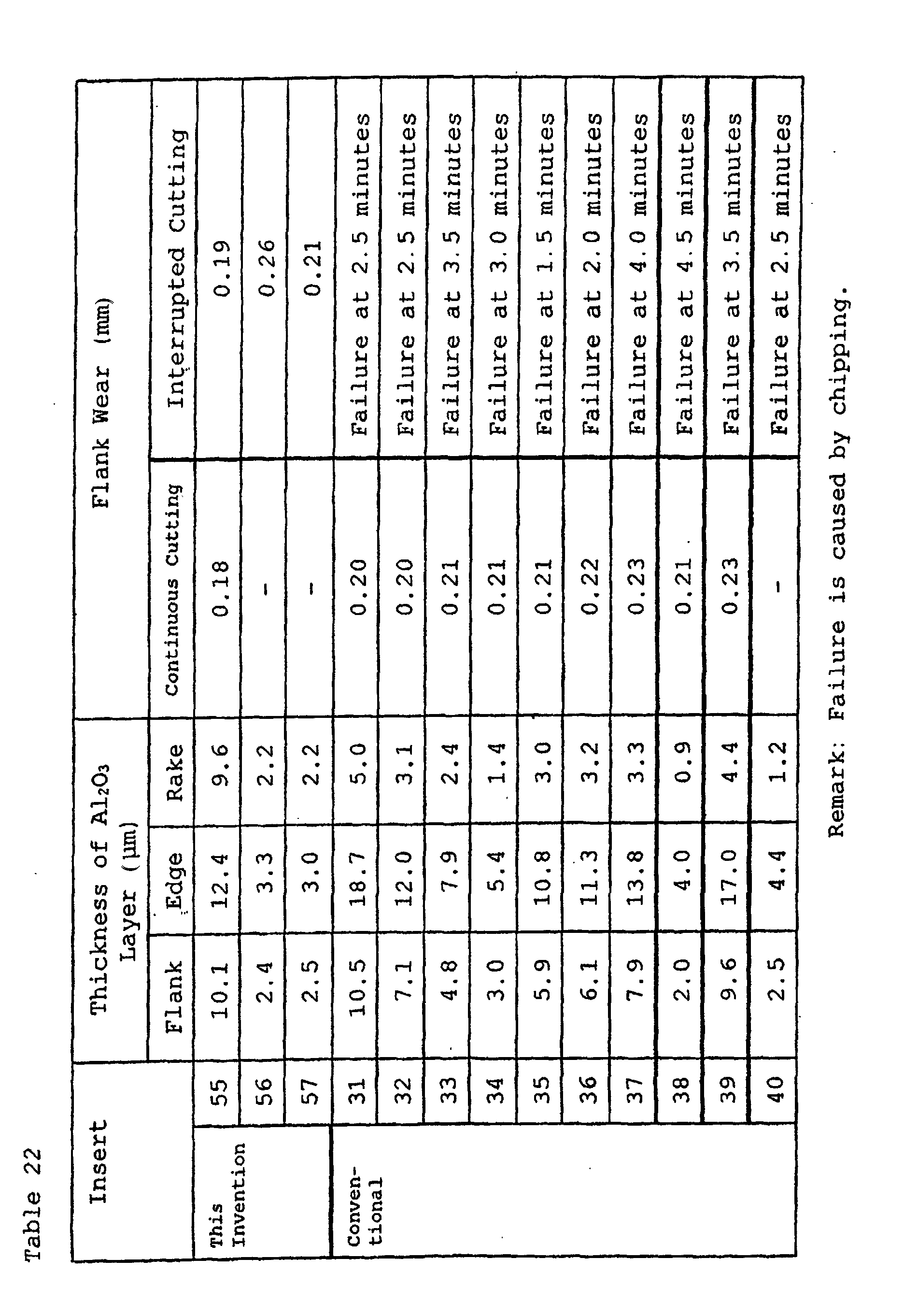

## Claims

1. A coated carbide alloy cutting member exhibiting excellent resistance against chipping comprising: a tungsten carbide substrate and hard coating layers including an aluminum oxide-based layer essentially consisting of aluminum oxide, said hard coating layers having an average thickness of 3 to 20 µm and being formed on said tungsten carbide substrate by chemical and/or physical vapor deposition;
said aluminum oxide-based layer containing 0.005 to 0.3 percent by weight of chlorine.

2. A coated carbide alloy cutting member exhibiting excellent resistance against chipping according to claim 1 comprising: a tungsten carbide substrate and hard coating layers wherein said hard coating layers comprise at least one layer selected from the group consisting of a titanium carbide layer, a titanium nitride layer, a titanium carbonitride layer, a titanium oxide layer, a titanium carboxide layer, a titanium nitroxide layer and a titanium carbonitroxide layer, and an aluminum oxide-based layer essentially consisting of aluminum oxide.

3. A coated carbide alloy cutting member according to claim 1 or 2, whereby
said aluminum oxide-based layer containing 1.5 to 15 percent by weight of titanium.

4. The coated carbide alloy cutting member according to any of claims 1, to 3,
said aluminum oxide-based layer containing 0.5 to 10 percent by weight of zirconium and/or hafnium.

5. The coated carbide alloy cutting member according to any of claims 1 to 4,
said aluminum oxide-based layer containing 1.5 to 15 percent by weight of titanium and 0.5 to 10 percent by weight of zirconium and/or hafnium.

## Patentansprüche

1. Beschichtetes Carbidlegierungs-Schneidteil, dass eine ausgezeichnete Beständigkeit gegen Absplittern zeigt, dass umfasst: ein Wolframcarbid-Substrat und Hartbeschichtungs-Schichten, die eine Schicht auf Aluminiumoxidbasis einschließen, die im wesentlichen aus Aluminiumoxid besteht, wobei die genannten Hartbeschichtungs-Schichten eine durchschnittliche Dicke von 3 bis 20 µm aufweisen und auf dem genannten Wolframcarbid-Substrat durch chemisches und/oder physikalisches Aufdampfen gebildet werden; und wobei die Schicht auf Aluminiumoxidbasis 0,005 bis 0,3 Gew.-% Chlor enthält.

2. Beschichtetes Carbidlegierungs-Schneidteil nach Anspruch 1, dass eine ausgezeichnete Beständigkeit gegen Absplittern zeigt, dass umfasst: ein Wolframcarbid-Substrat und Hartbeschichtungs-Schichten, worin die genannten Hartbeschichtungs-Schichten mindestens eine Schicht umfassen, die ausgewählt wird aus der Gruppe, die besteht aus: einer Titancarbid-Schicht, einer Titannitrid-Schicht, einer Titancarbonitrid-Schicht, einer TitanoxidSchicht, einer Titancorboxid-Schicht, einer Titannitroxid-Schicht und einer Titancarbonitroxid-Schicht, und eine Schicht auf Aluminiumoxidbasis, die im wesentlichen aus Aluminiumoxid besteht.

3. Beschichtetes Carbidlegierungs-Schneidteil nach Anspruch 1 oder 2, worin die genannte Schicht auf Aluminiumoxidbasis 1,5 bis 15 Gew.-% Titan enthält.

4. Beschichtetes Carbidleglerungs-Schneidteil nach irgendeinem der Ansprüche 1 bis 3, worin die genannte Schicht auf Aluminiumoxidbasis 0,5 bis 10 Gew.-% Zirkon und/oder Hafnium enthält.

5. Beschichtetes Carbidlegierungs-Schneidteil nach irgendeinem der Ansprüche 1 bis 4, worin die Schicht auf Aluminiumoxidbasis 1,5 bis 15 Gew.% Titan und 0,5 bis 10 Gew.% Zirkon und/oder Hafnium enthält.

## Revendications

1. Elément de coupe en alliage de carbure revêtu présentant une excellente résistance à la formation d'ébréchures comprenant : un substrat de carbure de tungstène et des couches de revêtement dur comprenant une couche à base d'oxyde d'aluminium constituée essentiellement d'oxyde d'aluminium, lesdites couches de revêtement dur présentant une épaisseur moyenne de 3 à 20 µm et étant formées sur ledit substrat de carbure de tungstène par dépôt chimique et/ou physique en phase vapeur,
ladite couche à base d'oxyde d'aluminium contient 0,005 à 0,3 pour cent en poids de chlore.

2. Elément de coupe en alliage de carbure revêtu présentant une excellente résistance vis-à-vis d'une formation d'ébréchures selon la revendication 1, comprenant : un substrat de carbure de tungstène et des couches de revêtement dur dans lequel lesdites couches de revêtement dur comprennent au moins une couche choisie parmi le groupe constitué d'une couche de carbure de titane, d'une couche de nitrure de titane, d'une couche de carbonitrure de titane, d'une couche d'oxyde de titane, d'une couche de carboxyde de titane, d'une couche de nitroxyde de titane et d'une couche de carbonitroxyde de titane, et une couche à base d'oxyde d'aluminium constituée essentiellement d'oxyde d'aluminium.

3. Elément de coupe en alliage de carbure revêtu selon la revendication 1 ou 2,
dans lequel ladite couche à base d'oxyde d'aluminium contient 1,5 à 15 pour cent en poids de titane.

4. Elément de coupe en alliage de carbure revêtu selon l'une quelconque des revendications 1 à 3,
ladite couche à base d'oxyde d'aluminium contenant 0,5 à 10 pour cent en poids de zirconium et/ou de hafnium.

5. Elément de coupe en alliage de carbure revêtu selon l'une quelconque des revendications 1 à 4,
ladite couche à base d'oxyde d'aluminium contenant 1,5 à 15 pour cent en poids de titane et 0,5 à 10 pour cent de zirconium et/ou de hafnium.
